(19) Europäisches Patentamt
European Patent Office
Office européen des brevets

(11) **EP 4 757 522 A1**

(12) **EUROPEAN PATENT APPLICATION**

(43) Date of publication:
**10.06.2026 Bulletin 2026/24**

(21) Application number: **25192062.5**

(22) Date of filing: **28.07.2025**

(51) International Patent Classification (IPC):
**H10B 43/10** (2023.01)　　**H10B 43/20** (2023.01)
**H10B 43/50** (2023.01)

(52) Cooperative Patent Classification (CPC):
**H10B 43/50;** H10B 43/10; H10B 43/20

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **09.12.2024 JP 2024214475**

(71) Applicant: **Kioxia Corporation
Tokyo 108-0023 (JP)**

(72) Inventors:
• **IKEDA, Mitsuo
108-0023 Minato-ku, Tokyo, (JP)**
• **IKENO, Daisuke
108-0023 Minato-ku, Tokyo, (JP)**

(74) Representative: **Hoffmann Eitle
Patent- und Rechtsanwälte PartmbB
Arabellastraße 30
81925 München (DE)**

(54) **SEMICONDUCTOR DEVICE AND METHOD OF MANUFACTURING THE SAME**

(57)　In one embodiment, a semiconductor device includes a substrate, and a stacked film provided on the substrate, and including plural insulators separated from each other in a first direction orthogonal to a surface of the substrate. The device further includes a first semiconductor layer provided between first and second insulators of the plural insulators, extending in a second direction orthogonal to the first direction, and being a channel semiconductor layer, and a second semiconductor layer provided on a side face of the first semiconductor layer between the first and second insulators, and having a different composition from the first semiconductor layer. The device further includes a metal layer on a side face of the second semiconductor layer, a first interconnect provided on a side face of the metal layer, and a second interconnect extending in the second direction, electrically connected to the first interconnect, and being a bit line.

FIG.40

**Description**

FIELD

Embodiments described herein relate to a semiconductor device and a method of manufacturing the same.

BACKGROUND

A known three-dimensional semiconductor memory includes a local block interconnect (LBI) between a channel semiconductor layer and a bit line. In this case, an impurity semiconductor layer is provided between the channel semiconductor layer and the LBI. However, when a native oxide film is formed on the surface of the impurity semiconductor layer, a problem arises in that the contact resistance between the impurity semiconductor layer and the LBI becomes high.

BRIEF DESCRIPTION OF THE DRAWINGS

FIG. 1 is a plan view schematically illustrating the structure of a semiconductor device of a first embodiment;
FIG. 2 is a plan view illustrating the structure of the semiconductor device of the first embodiment;
FIG. 3 is another plan view illustrating the structure of the semiconductor device of the first embodiment;
FIG. 4 is a perspective view illustrating the structure of the semiconductor device of the first embodiment;
FIG. 5 is another plan view illustrating the structure of the semiconductor device of the first embodiment;
FIG. 6 is a cross-sectional view illustrating the structure of the semiconductor device of the first embodiment;
FIG. 7 is another cross-sectional view illustrating the structure of the semiconductor device of the first embodiment;
FIGS. 8 to 39 are cross-sectional views illustrating a method of manufacturing the semiconductor device of the first embodiment;
FIG. 40 is a cross-sectional view illustrating the structure of the semiconductor device of the first embodiment;
FIG. 41 is a cross-sectional view illustrating the structure of a semiconductor device of a comparative example of the first embodiment;
FIGS. 42A to 45B are cross-sectional views illustrating the method of manufacturing the semiconductor device of the first embodiment;
FIG. 46 is a cross-sectional view illustrating the structure of a semiconductor device of a second embodiment;
FIGS. 47A and 47B are cross-sectional views illustrating a method of manufacturing the semiconductor device of the second embodiment;
FIG. 48 is a cross-sectional view illustrating the structure of a semiconductor device of a third embodiment; and
FIGS. 49A to 50B are cross-sectional views illustrating a method of manufacturing the semiconductor device of the third embodiment.

DETAILED DESCRIPTION

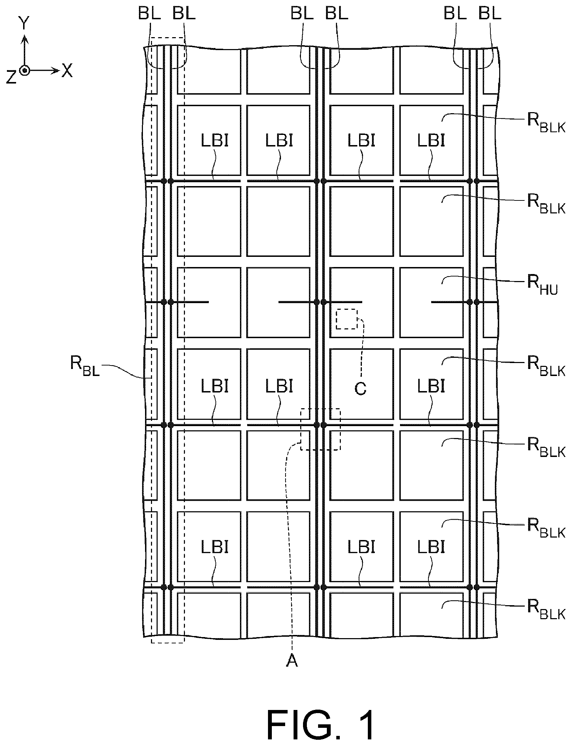

Embodiments will now be explained with reference to the accompanying drawings. In FIGS. 1 to 50B, identical components are denoted by the same reference sign, and duplicate description thereof is omitted.

In one embodiment, a semiconductor device includes a substrate, and a stacked film provided on the substrate, and including a plurality of insulators separated from each other in a first direction orthogonal to a surface of the substrate. The device further includes a first semiconductor layer provided between first and second insulators included in the plurality of insulators, and extending in a second direction orthogonal to the first direction, the first semiconductor layer being a channel semiconductor layer, and a second semiconductor layer provided on a side face of the first semiconductor layer between the first and second insulators, and having a composition different from a composition of the first semiconductor layer. The device further includes a first metal layer provided on a side face of the second semiconductor layer between the first and second insulators. The device further includes a first interconnect provided on a side face of the first metal layer between the first and second insulators, and a second interconnect extending in the second direction, and electrically connected to the first interconnect, the second interconnect being a bit line.

(First embodiment)

1) Structure of semiconductor device of first embodiment

FIG. 1 is a plan view schematically illustrating the structure of a semiconductor device of a first embodiment. The semiconductor device of the present embodiment is, for example, a three-dimensional semiconductor memory.

FIG. 1 illustrates an X direction, a Y direction, and a Z direction intersecting one another. The X and Y directions are parallel to the surface of a substrate to be described later and orthogonal to each other. The Z direction is orthogonal to the surface of the substrate to be described later. The Z, Y direction, and X directions are examples of first, second, and third directions, respectively.

The semiconductor device of the present embodiment includes a plurality of memory block regions $R_{BLK}$, a plurality of hook-up regions $R_{HU}$, a plurality of bit line regions $R_{BL}$, a plurality of bit lines BL, and a plurality of local block interconnects LBI. Each local block interconnect LBI is an example of a first interconnect. Each bit line BL is an example of a second interconnect.

The memory block regions $R_{BLK}$ are disposed in a matrix of rows and columns in the X and Y directions. The hook-up regions $R_{HU}$ are linearly disposed in the X direction and sandwiched between the memory block regions $R_{BLK}$. Each hook-up region $R_{HU}$ corresponds to a plurality of memory block regions $R_{BLK}$ linearly arranged on the positive and negative sides of the hook-up region $R_{HU}$ in the Y direction. The bit line regions $R_{BL}$ extend in the Y direction and are sandwiched between the memory block regions $R_{BLK}$ and between the hook-up regions $R_{HU}$. Each bit line region $R_{BL}$ corresponds to a plurality of memory block regions $R_{BLK}$ adjacent on the positive side of the bit line region $R_{BL}$ in the X direction and linearly arranged in the Y direction and to a plurality of memory block regions $R_{BLK}$ adjacent on the negative side of the bit line region $R_{BL}$ in the X direction and linearly arranged in the Y direction.

Each bit line BL extends in the Y direction and is disposed in the corresponding bit line region $R_{BL}$. Each local block interconnect LBI extends in the X direction and is disposed between two memory block regions $R_{BLK}$. Each local block interconnect LBI may extend in the Y direction as well as the X direction. Each local block interconnect LBI is electrically connected to the two memory block regions $R_{BLK}$ and electrically connected to the corresponding bit line BL. Each bit line BL is electrically connected to a non-illustrated peripheral circuit through the corresponding hook-up region $R_{HU}$. Although the bit lines BL and the local block interconnects LBI shown in FIG. 1 are disposed to have the same level (height) in the Z direction in FIG. 1, the bit lines BL and the local block interconnects LBI shown in FIG. 1 may alternatively be disposed to have different levels (heights) in the Z direction.

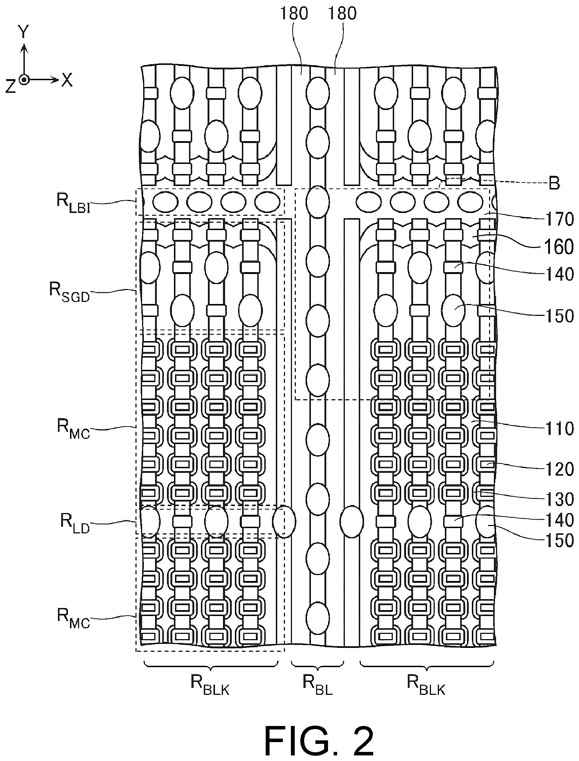

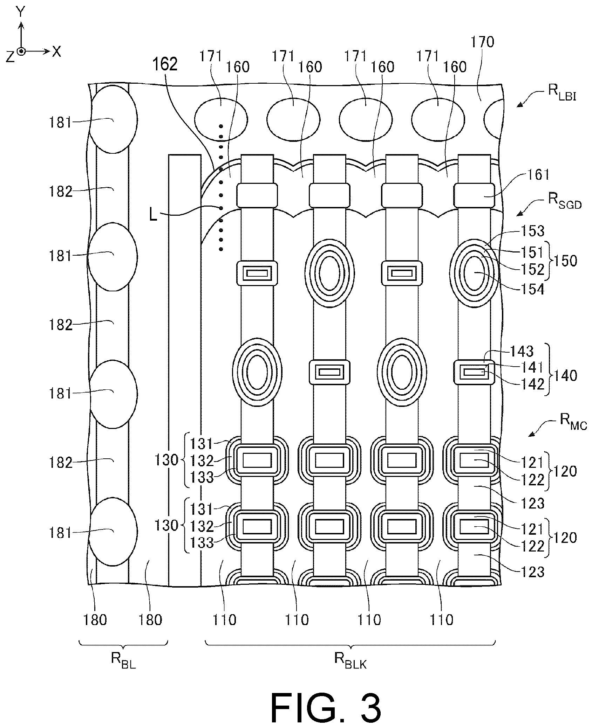

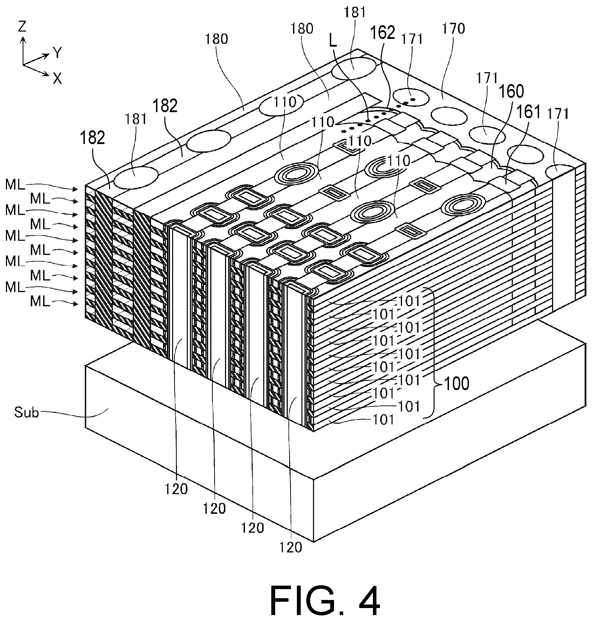

FIG. 2 is a plan view illustrating the structure of the semiconductor device of the first embodiment. FIG. 3 is another plan view illustrating the structure of the semiconductor device of the first embodiment. FIG. 4 is a perspective view illustrating the structure of the semiconductor device of the first embodiment.

FIG. 2 illustrates region A in FIG. 1 in an enlarged manner. FIG. 3 illustrates region B in FIG. 2 in an enlarged manner. FIG. 4 is a perspective view corresponding to the plan view of FIG. 3. FIG. 2 illustrates two memory block regions $R_{BLK}$ and one bit line region $R_{BL}$, and FIGS. 3 and 4 illustrate one memory block region $R_{BLK}$ and one bit line region $R_{BL}$.

In FIG. 2, each memory block region $R_{BLK}$ includes two memory cell regions $R_{MC}$ adjacent to each other in the Y direction, and one ladder region $R_{LD}$ provided between the two memory cell regions $R_{MC}$. FIG. 2 further illustrates a selection transistor region $R_{SGD}$ provided on the positive side of each memory block region $R_{BLK}$ in the Y direction, and a local block interconnect region $R_{LBI}$ provided on the positive side of the selection transistor region $R_{SGD}$ in the Y direction. Each local block interconnect region $R_{LBI}$ extends in the X direction and includes above-described local block interconnects LBI. Each local block interconnect region $R_{LBI}$ of the present embodiment is provided between two memory block regions $R_{BLK}$ adjacent to each other in the Y direction.

As illustrated in FIG. 4, the semiconductor device of the present embodiment includes a substrate Sub and a stacked film 100 formed above the substrate Sub.

The substrate Sub is, for example, a semiconductor substrate such as a silicon (Si) substrate. The substrate Sub may be a Si substrate including P-type impurity such as boron (B). In FIG. 4, the X and Y directions are parallel to the surface of the substrate Sub, and the Z direction is orthogonal to the surface of the substrate Sub.

The stacked film 100 includes a plurality of insulators 101 and a plurality of memory layers ML alternately stacked in the Z direction. The plurality of insulators 101 are separated from each other in the Z direction. Each insulator 101 is, for example, a silicon oxide film ($SiO_2$ film). Two insulators 101 adjacent to each other among the plurality of insulators 101 are examples of first and second insulators.

Each memory layer ML includes a plurality of semiconductor layers 110. The plurality of semiconductor layers 110 are adjacent to each other in the X direction and extend in the Y direction. In FIG. 2, each semiconductor layer 110 extends in the plurality of memory cell regions $R_{MC}$, the ladder region $R_{LD}$, and the selection transistor region $R_{SGD}$. Each semiconductor layer 110 functions as a channel region of a plurality of memory transistors (memory cells) and a plurality of selection transistors (selection gates). The plurality of memory transistors and the plurality of selection transistors are electrically connected in series and referred to as a memory string. Each semiconductor layer 110 is, for example, a polysilicon layer. The polysilicon layer is, for example, an undoped polysilicon layer. Each semiconductor layer 110 is an example of the first semiconductor layer.

Each memory cell region $R_{MC}$ includes a plurality of electrode layers 120 extending in the Z direction so as to penetrate through the stacked film 100. In FIG. 3, a plurality of electrode layers 120 are arranged in the Y direction between two semiconductor layers 110 adjacent to each other in the X direction. In FIG. 3, an insulator 123 is formed between two electrode layers 120 adjacent to each other in the Y direction. Similarly to the electrode layers 120, the insulators 123 extend in the Z direction in the stacked film 100. Each electrode layer 120 includes a column-shaped electrode material layer 122 extending in the Z direction, and a tubular barrier metal layer 121 extending in the Z direction around the electrode material layer 122. The barrier metal layer 121 is, for example, a titanium nitride film (TiN film). The electrode material layer 122 is, for example, a tungsten (W) layer. The insulator 123 is, for example, a $SiO_2$ film. Each electrode layer 120 functions as a gate electrode or word line of a plurality of memory transistors.

Each memory cell region $R_{MC}$ further includes a plurality of memory insulators 130 extending in the Z direction so as to penetrate through the stacked film 100. Each memory insulator 130 includes a block insulator 133, a plurality of charge storage layers 132, and a plurality of tunnel insulators 131. The block insulator 133 has a tubular shape extending in the Z direction around the corresponding electrode layer 120. In one memory layer ML, each charge storage layer 132 is formed on a side face of the block insulator 133 on the positive side in the X direction or the negative side in the X direction. In one memory layer ML, each tunnel insulator 131 is formed on the side face of the block insulator 133 on the positive side in the X direction or the negative side in the X direction with the charge storage layers 132 interposed therebetween. Each tunnel insulator 131 further contacts a side face of the corresponding semiconductor layer 110. Each tunnel insulator 131 is, for example, a $SiO_2$ film. Each charge storage layer 132 is, for example, a polysilicon layer or a silicon nitride film (SiN film). The polysilicon layer is, for example, an undoped P-type or N-type polysilicon layer. The block insulator 133 is, for example, a $SiO_2$ film and/or a metal oxide film. The metal oxide film is, for example, an aluminum oxide film or a hafnium oxide film. Each charge storage layer 132 can store electric charge of the three-dimensional semiconductor memory.

Each ladder region $R_{LD}$ or each selection transistor region $R_{SGD}$ includes a plurality of contact plugs 140 extending in the Z direction in the stacked film 100. In FIG. 3, each contact plug 140 is provided between two semiconductor layers 110 adjacent to each other in the X direction. Each contact plug 140 is used to form a hole channel in the semiconductor layer 110 and supply voltage to a hole channel formed in the semiconductor layer 110. Each contact plug 140 includes a column-shaped metal layer 142 extending in the Z direction, a tubular semiconductor layer 141 extending in the Z direction around the metal layer 142, and a tubular semiconductor layer 143 extending in the Z direction around the semiconductor layer 141. The metal layer 142 is, for example, a TiN film. The semiconductor layer 141 is, for example, a P-type polysilicon layer. The semiconductor layer 143 is, for example, an undoped polysilicon layer. Each contact plug 140 does not necessarily need to include the semiconductor layer 143. Each contact plug 140 is provided between two insulators 123 adjacent to each other in the Y direction.

Each ladder region $R_{LD}$ or selection transistor region $R_{SGD}$ further includes a plurality of electrode layers 150 extending in the Z direction in the stacked film 100. In FIG. 3, each electrode layer 150 is provided between two semiconductor layers 110 adjacent to each other in the X direction. Each electrode layer 150 functions as a gate electrode or gate interconnect of a transistor. Each electrode layer 150 includes a tubular metal layer 152 extending in the Z direction around an insulator 154, and a tubular semiconductor layer 151 extending in the Z direction around the metal layer 152. The insulator 154 has a column shape extending in the Z direction. The semiconductor layer 151 has a side face covered with an insulator 153. The insulator 153 has a tubular shape extending in the Z direction around the semiconductor layer 151. The insulator 154 is, for example, a $SiO_2$ film. The metal layer 152 is, for example, a TiN film. The semiconductor layer 151 is, for example, an N-type polysilicon layer. The insulator 153 is, for example, a $SiO_2$ film. Each electrode layer 150 is provided between two insulators 123 adjacent to each other in the Y direction.

In each selection transistor region $R_{SGD}$, each memory layer ML includes a plurality of semiconductor layers 160 and a plurality of metal layers 162. Each semiconductor layer 160 is formed on a side face of the corresponding semiconductor layer 110. Each semiconductor layer 160 is, for example, an impurity semiconductor layer, and more specifically, a polysilicon layer including N-type impurity such as phosphorus (P). Each metal layer 162 is formed on a side face of the corresponding semiconductor layer 160. Each metal layer 162 is, for example, a tungsten (W) layer, a molybdenum (Mo) layer, a technetium (Tc) layer, a ruthenium (Ru) layer, a rhodium (Rh) layer, a rhenium (Re) layer, an osmium (Os) layer, an iridium (Ir) layer, or a platinum (Pt) layer. Each semiconductor layer 160 is an example of the second semiconductor layer, and each metal layer 162 is an example of a first metal layer. Each selection transistor region $R_{SGD}$ further includes a plurality of insulators 161. Each insulator 161 extends in the Z direction in the stacked film 100 and is formed between two semiconductor layers 160 adjacent to each other in the X direction. Each insulator 161 is, for example, a $SiO_2$ film.

In each local block interconnect region $R_{LBI}$, each memory layer ML includes an interconnect layer 170. The interconnect layer 170 is formed on side faces of the plurality of metal layers 162. The interconnect layer 170, the plurality of semiconductor layers 160 and the plurality of semiconductor layers 110 are electrically connected with each other. The interconnect layer 170 extends in the X direction and functions as the local block interconnects LBI. The interconnect layer 170 is, for example, a conductive metal layer. The interconnect layer 170 (local block interconnects LBI) is an example of the first interconnect as described above. Each local block interconnect region $R_{LBI}$ further includes a plurality of insulators 171 arranged in the X direction. Each insulator 171 extends in the Z direction in the stacked film 100 and penetrates through the plurality of interconnect layers 170. Each insulator 171 is, for example, a $SiO_2$ film.

In each bit line regions $R_{BL}$, each memory layer ML includes an interconnect layer 180. The interconnect layer 180 is electrically connected to the interconnect layer 170. The interconnect layer 180 extends in the Y direction and functions as a bit line BL. The interconnect layer 180 is, for example, a conductive metal layer. The interconnect layer 170 and the interconnect layer 180 may be formed by processing the same interconnect material or different interconnect materials. In other words, the interconnect layer 170 and the interconnect layer 180 may be different portions of the same layer or may be different layers. The interconnect layer 180 (bit line BL) is an example of the second interconnect as described above. Each bit line region $R_{BL}$ further includes a plurality of insulators 181 and a plurality of insulators 182 alternately arranged in the Y direction. The insulators 181 and 182 extend in the Z direction in the stacked film 100. Each insulator 181 is, for example, a $SiO_2$ film. Each insulator 182 is, for example, a $SiO_2$ film. In the bit line regions $R_{BL}$ in FIG. 2, the insulators 181 and 182 are disposed between two interconnect layers 180 (bit lines BL) adjacent to each other in the X direction.

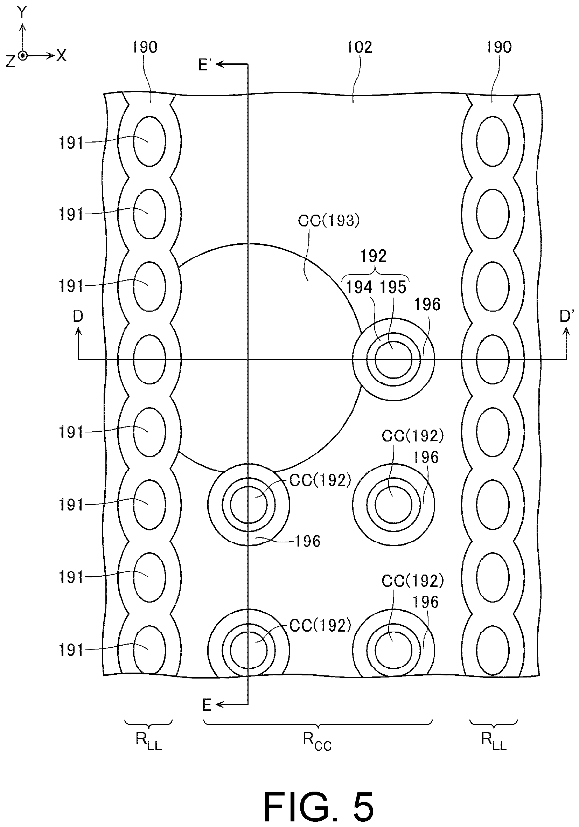

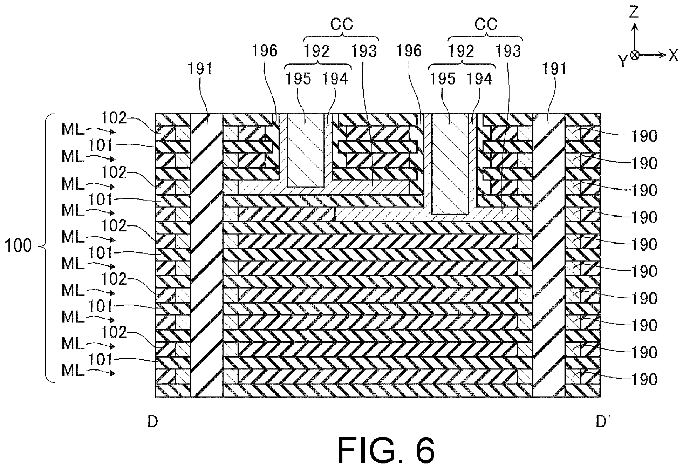

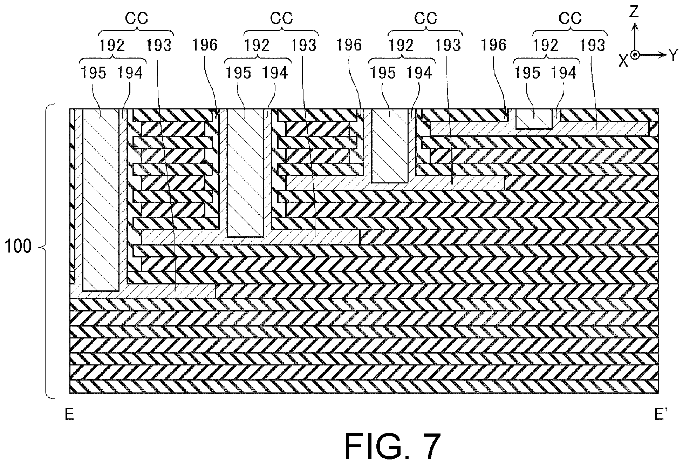

FIG. 5 is another plan view illustrating the structure of the semiconductor device of the first embodiment. FIG. 6 is a cross-sectional view illustrating the structure of the semiconductor device of the first embodiment. FIG. 7 is another cross-sectional view illustrating the structure of the semiconductor device of the first embodiment.

FIG. 5 illustrates region C in FIG. 1 in an enlarged manner. FIG. 6 is a cross-sectional view of an XZ section along line D-D' illustrated in FIG. 5 when viewed in the direction of arrows. FIG. 7 is a cross-sectional view of a YZ section along line E-E' illustrated in FIG. 5 when viewed in the direction of arrows.

Each hook-up region $R_{HU}$ of the present embodiment includes a plurality of lead-out line regions $R_{LL}$ and a plurality of contact electrode regions $R_{CC}$ alternately provided in the X direction. FIG. 5 illustrates two lead-out line regions $R_{LL}$ adjacent to each other in the X direction and a contact electrode region $R_{CC}$ provided between the two lead-out line regions $R_{LL}$.

As illustrated in FIGS. 6 and 7, the stacked film 100 includes the plurality of insulators 101 and a plurality of insulators 102 alternately stacked in the Z direction. Each insulator 102 is a portion of any one memory layer ML in the stacked film 100. Each insulator 102 is, for example, a SiN film.

In each lead-out line region $R_{LL}$, each memory layer ML includes a plurality of interconnect layers 190 extending in the Y direction. Each interconnect layer 190 is, for example, a conductive metal layer. Each interconnect layer 190 is electrically connected to the corresponding interconnect layer 180 and, accordingly, electrically connected to the corresponding interconnect layer 170.

Each lead-out line region $R_{LL}$ further includes a plurality of insulators 191 extending in the Z direction in the stacked film 100. In each lead-out line region $R_{LL}$, the plurality of insulators 191 are adjacent to each other in the Y direction and penetrate through the plurality of interconnect layers 190. Each insulator 191 is, for example, a

$SiO_2$ film.

Each contact electrode region $R_{CC}$ includes a plurality of contact electrodes CC provided in the stacked film 100. Each contact electrode CC includes a cylindrical portion 192 and a disk-shaped portion 193 provided below the portion 192. The portion 192 penetrates through one or more insulators 101 and has a side face covered with an insulator 196. The portion 193 is provided in any one memory layer ML in the stacked film 100 and electrically connected to one interconnect layer 190 in the one memory layer ML. The portion 192 includes an electrode material layer 195 extending in the Z direction, and a barrier metal layer 194 extending in the Z direction around the electrode material layer 195. The portion 193 is, for example, a TiN film. The barrier metal layer 194 is, for example, a TiN film. The electrode material layer 195 is, for example, a tungsten (W) layer. The insulator 196 is, for example, a $SiO_2$ film.

2) Method of manufacturing semiconductor device of first embodiment

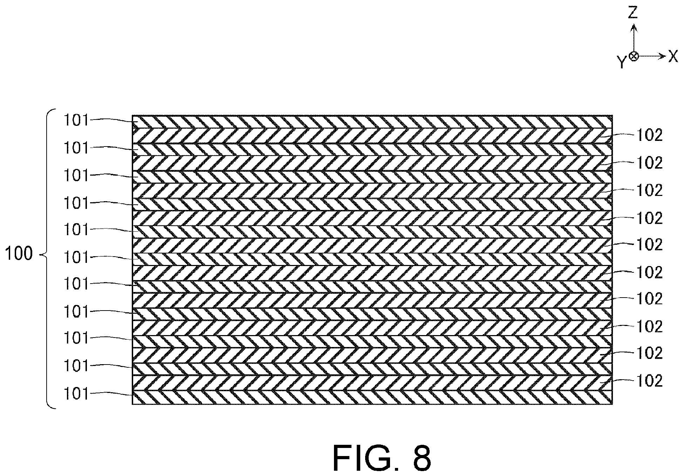

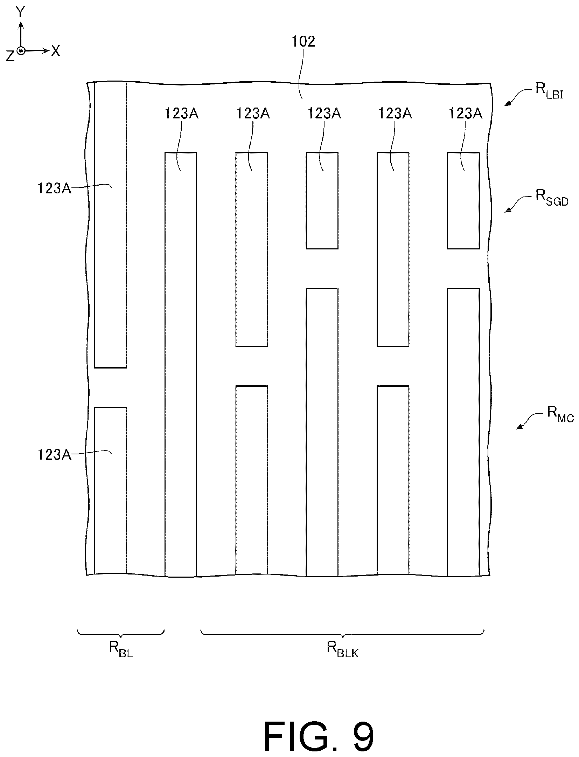

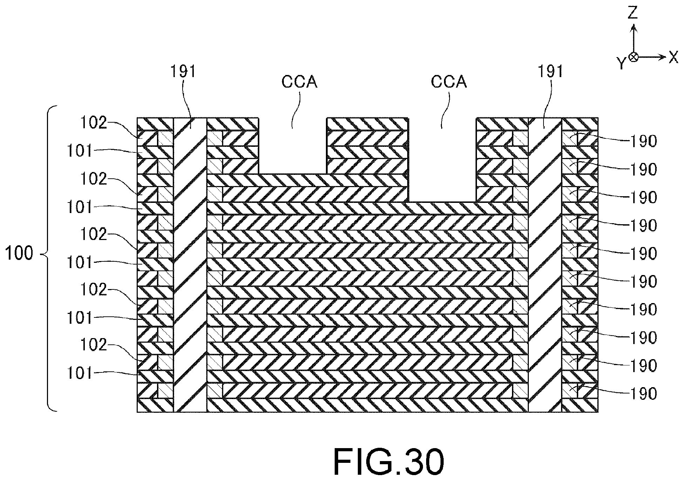

FIGS. 8 to 39 are cross-sectional views and plan views illustrating a method of manufacturing the semiconductor device of the first embodiment. The cross-sectional views in FIG. 8 and other diagrams correspond to cross-sectional views at the position of one XZ section along which the stacked film 100 illustrated in FIG. 4 is cut. The plan views in FIG. 9 and other diagrams correspond to the plan view in FIG. 3. The cross-sectional views in FIGS. 30 to 39 correspond to the cross-sectional views in FIGS. 6 and 7.

First, the stacked film 100 is formed above the above-described substrate Sub (not illustrated) (FIG. 8). The stacked film 100 is formed by alternately stacking the plurality of insulators 101 and the plurality of insulators 102 above the substrate Sub. The stacked film 100 illustrated in FIG. 8 alternately includes the plurality of insulators 101 and the plurality of insulators 102 in the Z direction. The plurality of insulators 101 and the plurality of insulators 102 are formed by, for example, chemical vapor deposition (CVD).

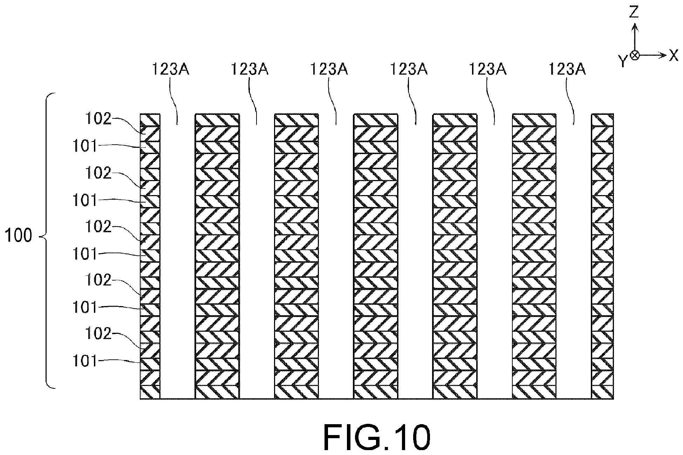

Subsequently, a plurality of concave portions 123A are formed in the stacked film 100 by lithography and reactive ion etching (RIE) (FIGS. 9 and 10). The plurality of concave portions 123A extend in the Y and Z directions and are adjacent to each other in the X or Y direction.

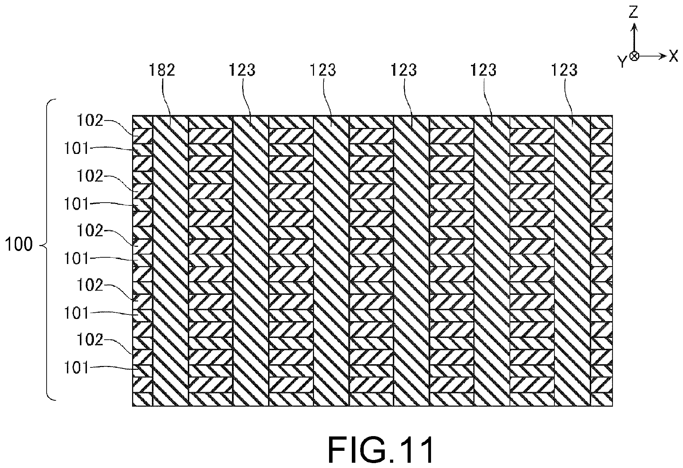

Subsequently, the plurality of insulators 123 and the plurality of insulators 182 are formed in the plurality of concave portions 123A by CVD (FIG. 11). The insulators 123 are formed in the concave portions 123A in each memory block region $R_{BLK}$, and the insulators 182 are formed in the concave portions 123A in each bit line region $R_{BL}$.

Subsequently, a plurality of concave portions 120A, a plurality of contact holes 140A, and a plurality of concave portions 161A are formed in the stacked film 100

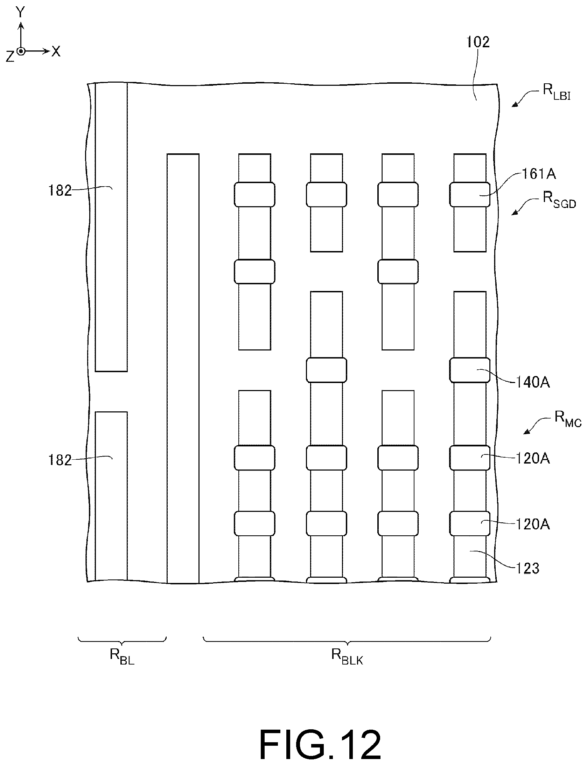

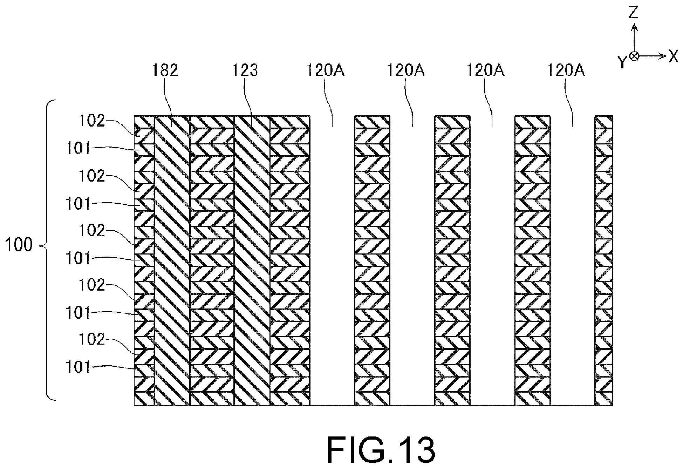

and the plurality of insulators 123 by lithography and RIE (FIGS. 12 and 13). The concave portions 120A, the contact holes 140A, and the concave portions 161A penetrate through the stacked film 100 in the Z direction. In the process illustrated in FIGS. 12 and 13, a plurality of concave portions (not illustrated) are also formed in regions corresponding to the plurality of above-described insulators 191.

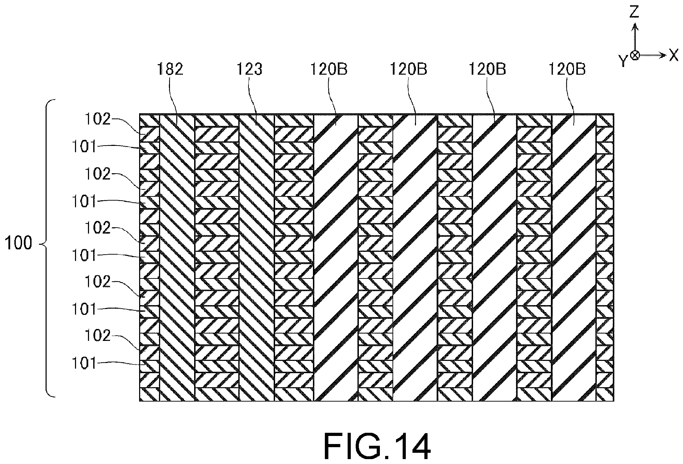

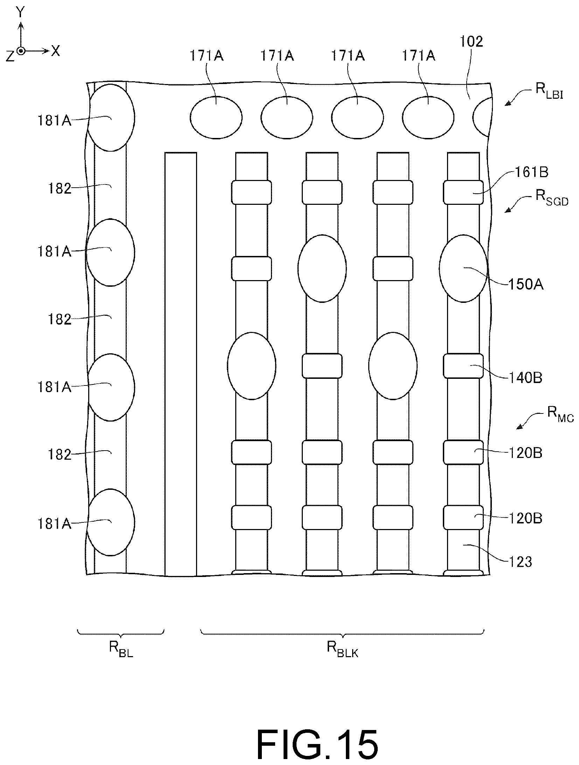

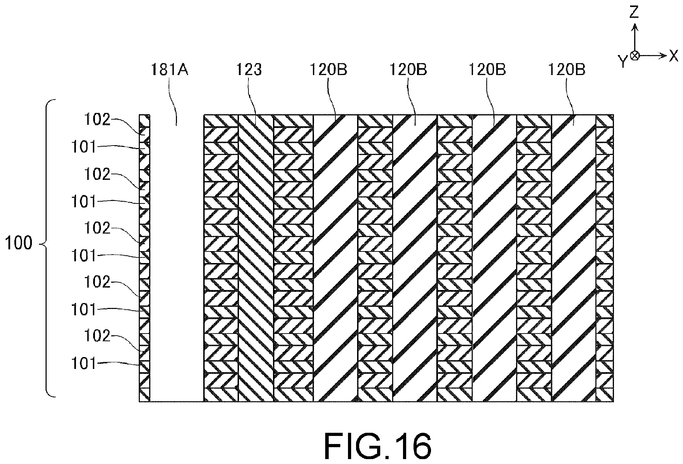

Subsequently, a plurality of sacrifice layers 120B are formed in the plurality of concave portions 120A by CVD (FIG. 14). Subsequently, a plurality of sacrifice layers 140B are formed in the plurality of contact holes 140A by CVD (FIGS. 15 and 16). Subsequently, a plurality of sacrifice layers 161B are formed in the plurality of concave portions 161A by CVD (FIGS. 15 and 16). In the process illustrated in FIGS. 15 and 16, a plurality of sacrifice layers (not illustrated) are also formed in regions corresponding to the plurality of above-described insulators 191. The sacrifice layers 120B, 140B, and 161B may be simultaneously formed. This is the same for sacrifice layers corresponding to the insulators 191.

Subsequently, a plurality of concave portions 150A, a plurality of concave portions 171A, and a plurality of concave portions 181A are formed in the stacked film 100 by lithography and RIE (FIGS. 15 and 16). The concave portions 150A, 171A, and 181A penetrate through the stacked film 100 in the Z direction. Each concave portion 150A is formed between two insulators 123 adjacent to each other in the Y direction. Each concave portion 181A is formed in one insulator 182 or formed between two insulators 182 adjacent to each other in the Y direction. In each local block interconnect region $R_{LBI}$, the plurality of concave portions 171A are formed alongside in the X direction.

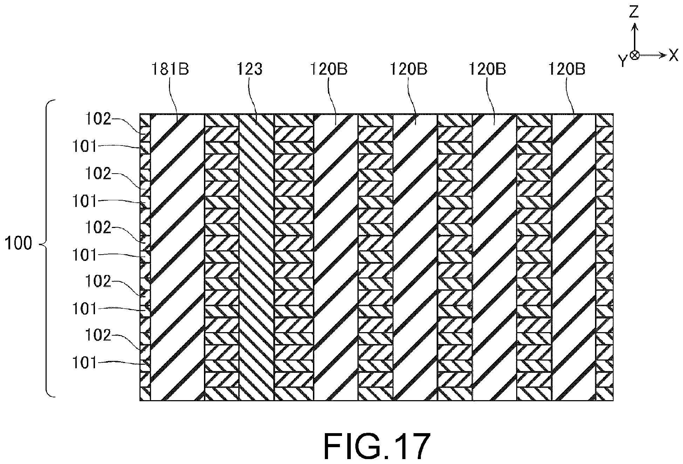

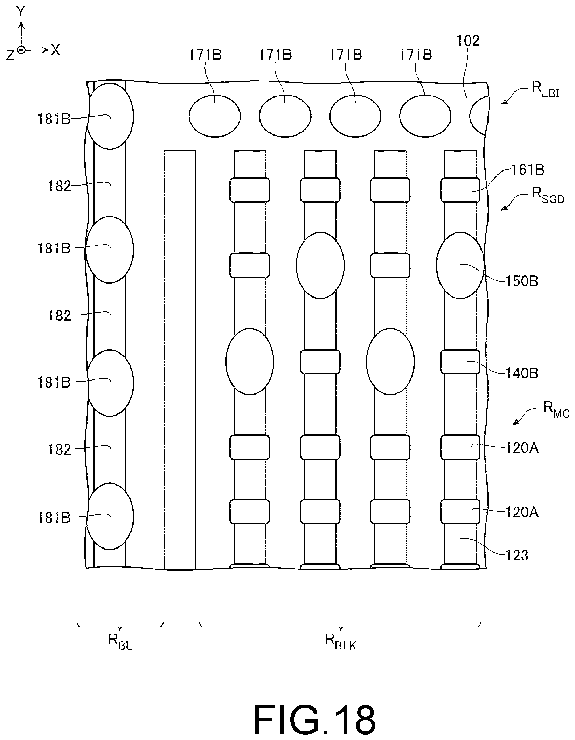

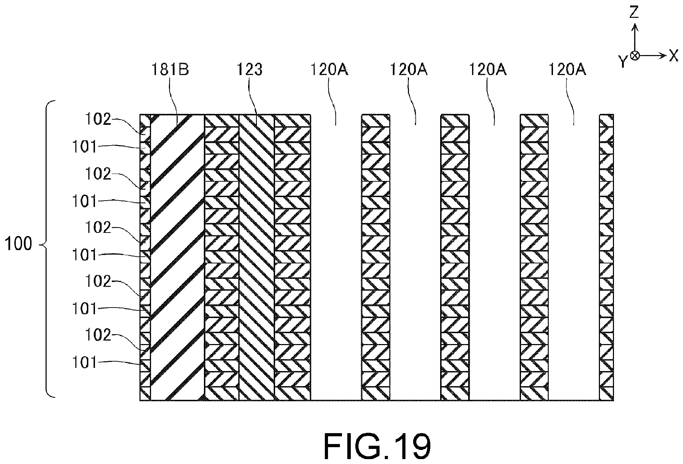

Subsequently, a plurality of sacrifice layers 181B are formed in the plurality of concave portions 181A by CVD (FIG. 17). Subsequently, a plurality of sacrifice layers 150B are formed in the plurality of concave portions 150A by CVD (FIGS. 18 and 19). Subsequently, a plurality of sacrifice layers 171B are formed in the plurality of concave portions 171A by CVD (FIGS. 18 and 19). The sacrifice layers 181B, 150B, and 171B may be simultaneously formed.

Subsequently, the plurality of sacrifice layers 120B are removed from the plurality of concave portions 120A by wet etching (FIGS. 18 and 19).

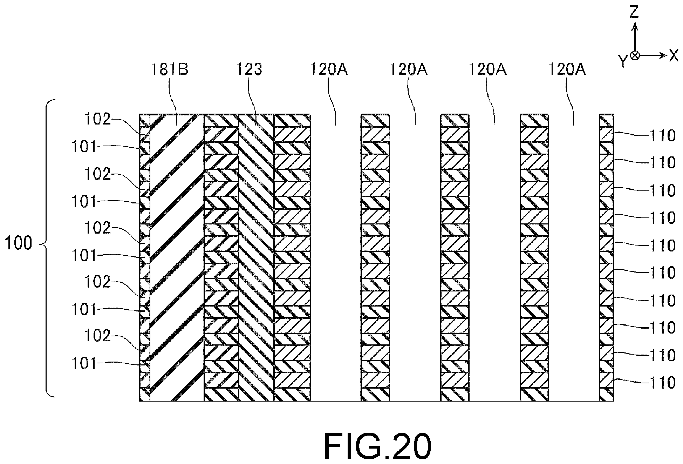

Subsequently, the plurality of semiconductor layers 110 are formed in the stacked film 100 (FIG. 20). Each semiconductor layer 110 is formed by, for example, replacing a portion of one insulator 102 with the semiconductor layer 110. Specifically, portions of the plurality of insulators 102 are removed by wet etching through the plurality of concave portions 120A to form a plurality of hollow spaces in the stacked film 100, and the plurality of semiconductor layers 110 are formed in the plurality of hollow spaces by CVD. As a result, each semiconductor layer 110 is formed between two insulators 101 adjacent to each other in the Z direction. In the process in FIG. 20, not all of each semiconductor layer 110 illustrated in FIG. 3 and other diagrams but a portion of the semiconductor layer 110 is formed.

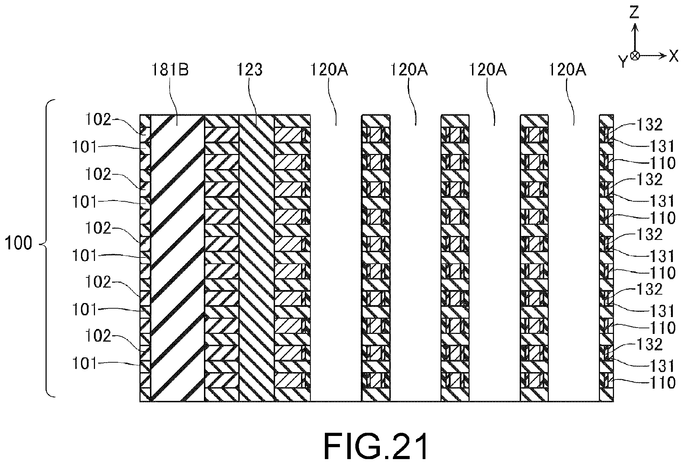

Subsequently, the plurality of tunnel insulators 131 and the plurality of charge storage layers 132 are formed in the stacked film 100 (FIG. 21). Between two insulators 101 adjacent to each other in the Z direction, one tunnel insulator 131 and one charge storage layer 132 are sequentially formed on one side face of one semiconductor layer 110 from the semiconductor layer 110 toward the corresponding concave portion 120A. For example, portions of the plurality of semiconductor layers 110 are removed by wet etching through the plurality of concave portions 120A to form a plurality of hollow spaces in the stacked film 100, and the plurality of tunnel insulators 131 and the plurality of charge storage layers 132 are formed in the plurality of hollow spaces by CVD. The tunnel insulators 131 may be formed by oxidizing the semiconductor layers 110 in place of CVD.

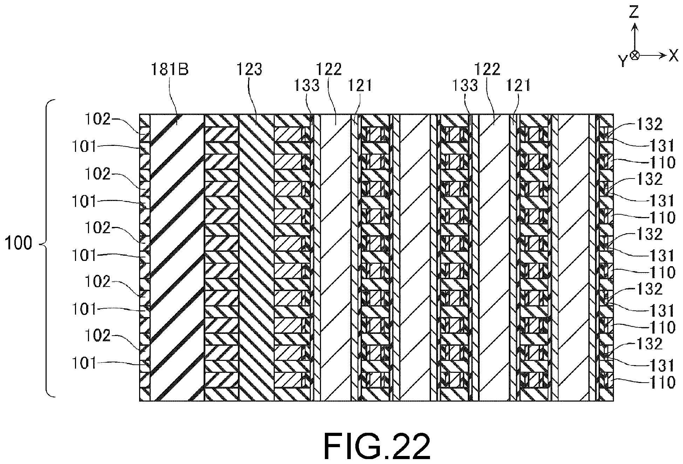

Subsequently, the block insulator 133, the barrier metal layer 121, and the electrode material layer 122 are sequentially formed in each concave portion 120A by CVD (FIG. 22).

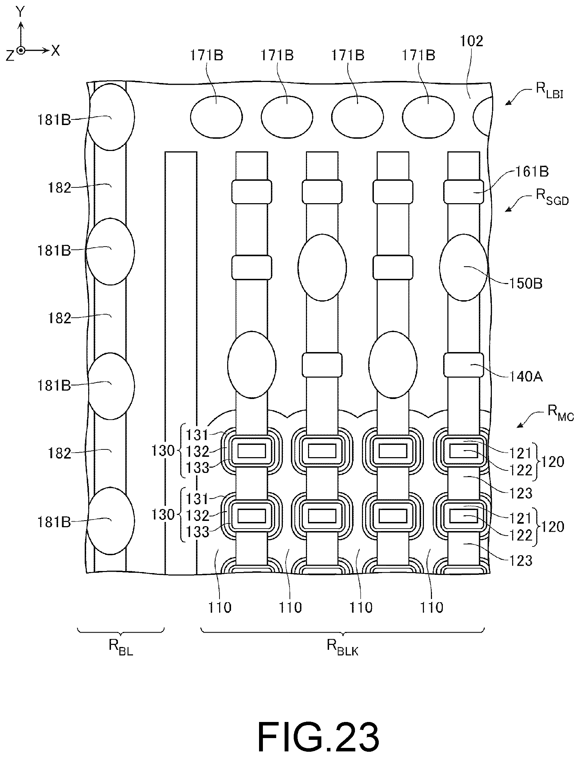

Subsequently, the plurality of sacrifice layers 140B are removed from the plurality of contact holes 140A by wet etching (FIG. 23).

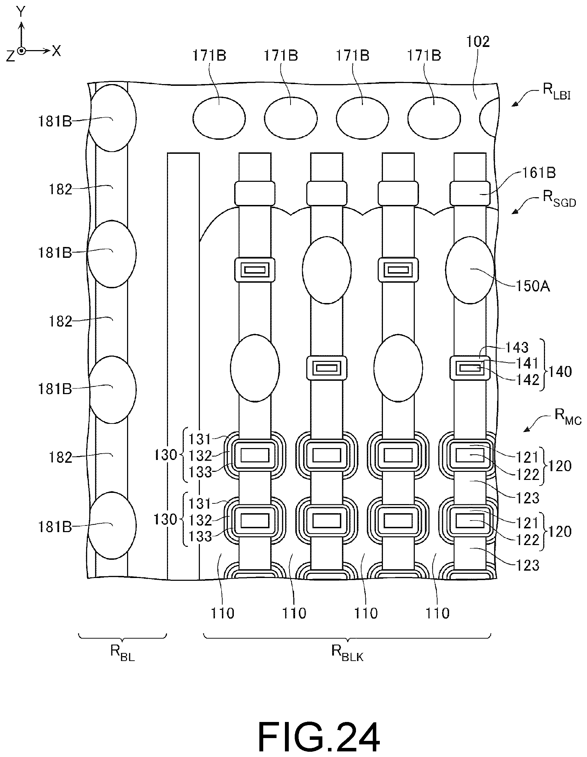

Subsequently, the rest of each semiconductor layer 110 is formed in the stacked film 100 (FIG. 24). The rest of each semiconductor layer 110 is formed by, for example, replacing a portion of one insulator 102 with the semiconductor layer 110 as in the process in FIG. 20. Specifically, portions of the plurality of insulators 102 are removed by wet etching through the plurality of contact holes 140A to form a plurality of hollow spaces in the stacked film 100, and the plurality of semiconductor layers 110 are formed in the plurality of hollow spaces by CVD. Each semiconductor layer 110 is formed between two insulators 101 adjacent to each other in the Z direction.

Subsequently, the semiconductor layer 143, the semiconductor layer 141, and the metal layer 142 are sequentially formed in each contact hole 140A by CVD (FIG. 24). As a result, one contact plug 140 is formed in each contact hole 140A.

Subsequently, the plurality of sacrifice layers 150B are removed from the plurality of concave portions 150A by wet etching (FIG. 24).

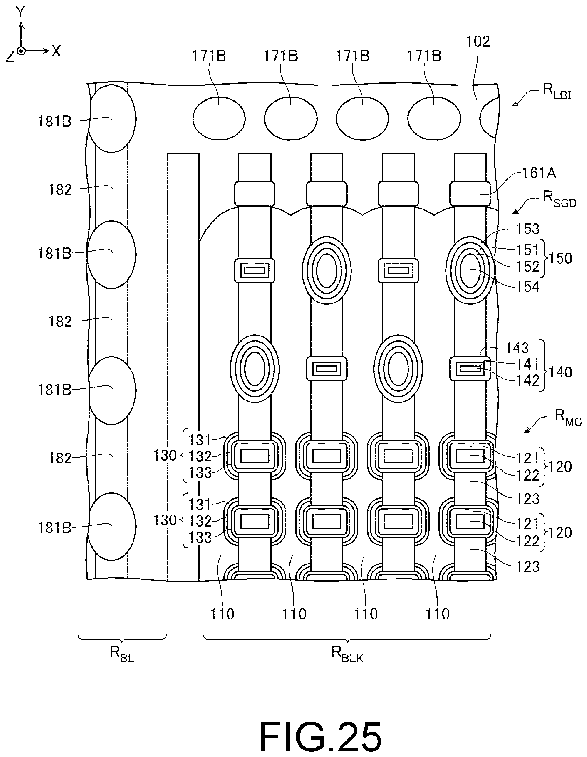

Subsequently, the insulator 153, the semiconductor layer 151, the metal layer 152, and the insulator 154 are sequentially formed in each concave portion 150A by CVD (FIG. 25). As a result, the electrode layers 150 is formed in the respective concave portions 150A.

Subsequently, the plurality of sacrifice layers 161B are removed from the plurality of concave portions 161A by wet etching (FIG. 25).

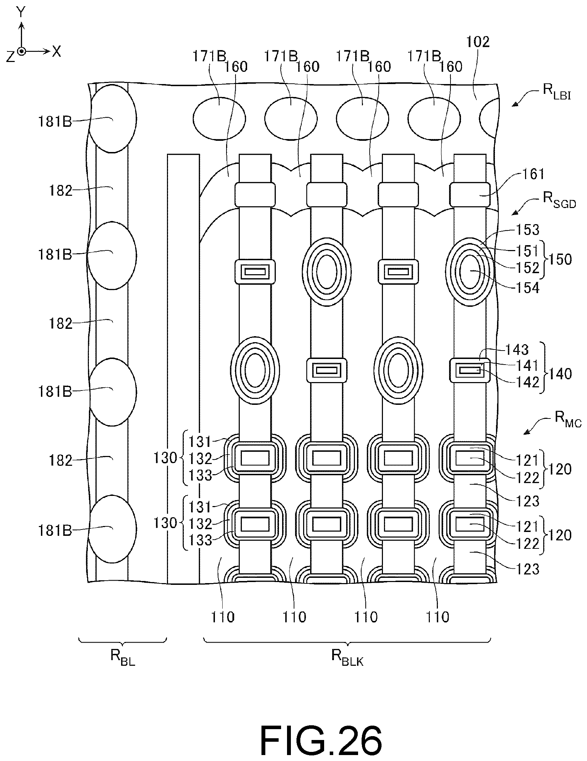

Subsequently, the plurality of semiconductor layers 160 are formed in the stacked film 100 (FIG. 26). Each semiconductor layer 160 is formed by, for example, replacing a portion of one insulator 102 with the semiconductor layer 160. Specifically, portions of the plurality of insulators 102 are removed by wet etching through the plurality of concave portions 161A to form a plurality of hollow spaces in the stacked film 100, and the plurality of semiconductor layers 160 are formed in the plurality of hollow spaces by CVD. Between two insulators 101 adjacent to each other in the Z direction, one semiconductor layer 160 is formed on a side face of one semiconductor layer 110. Further details of the semiconductor layers 160 will be described later.

Subsequently, the insulators 161 are formed in the respective concave portions 161A by CVD (FIG. 26).

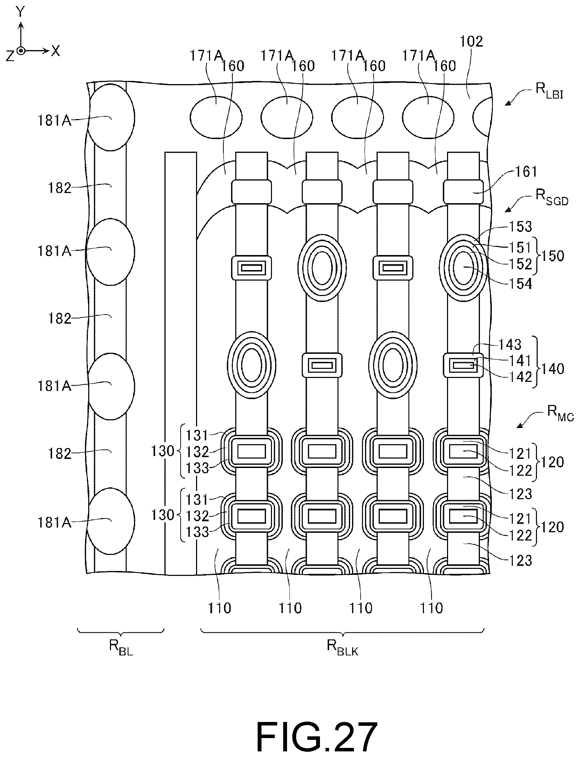

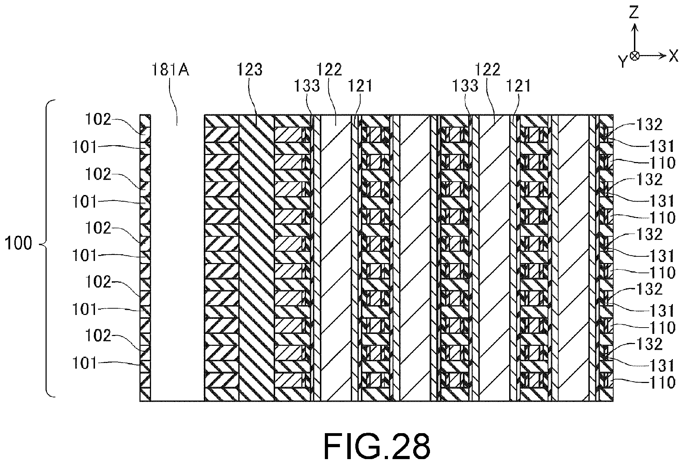

Subsequently, the plurality of sacrifice layers 171B and the plurality of sacrifice layers 181B are removed from the plurality of concave portions 171A and the plurality of concave portions 181A, respectively, by wet etching (FIGS. 27 and 28). In the process illustrated in FIGS. 27 and 28, a plurality of sacrifice layers are also removed from regions corresponding to the plurality of above-described insulators 191.

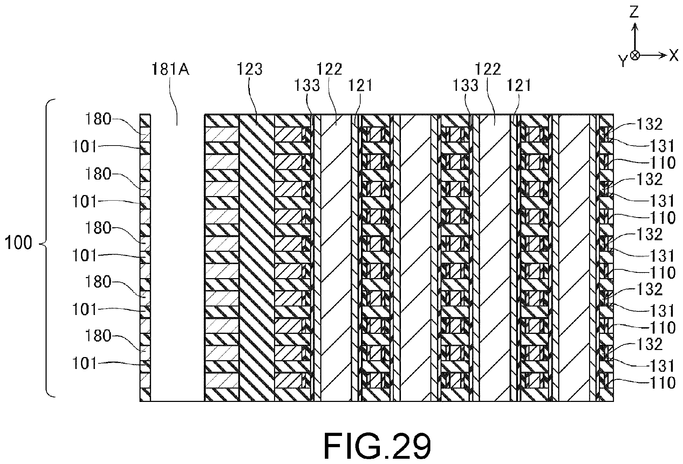

Subsequently, the plurality of metal layers 162 (not illustrated), the plurality of interconnect layers 170 (not illustrated), the plurality of interconnect layers 180, and the plurality of interconnect layers 190 (not illustrated) are formed in the stacked film 100 (FIG. 29). Each of the metal layers 162 and the interconnect layers 170, 180, and 190 is formed by, for example, replacing a portion of one insulator 102 with the metal layer 162 or the interconnect layer 170, 180, or 190. Specifically, portions of the plurality of insulators 102 are removed by wet etching through the plurality of concave portions 171A, the plurality of concave portions 181A, and the like to form a plurality of hollow spaces in the stacked film 100, and the plurality of metal layers 162, the plurality of interconnect layers 170, the plurality of interconnect layers 180, and the plurality of interconnect layers 190 are formed in the plurality of hollow spaces. Between two insulators 101 adjacent to each other in the Z direction, one metal layer 162 is formed on a side face of one semiconductor layer 160, one interconnect layer 170 is formed on side faces of the plurality of metal layers 162, and one interconnect layer 180 is formed so as to be electrically connected to the corresponding interconnect layer 170. Further details of the metal layers 162 and the like will be described later. Thereafter, the insulators 171, 181, and 191 are formed in the concave portions 171A and 181A and the like by CVD. The interconnect layers 190 and the insulators 191 are illustrated in FIG. 30 to be described later.

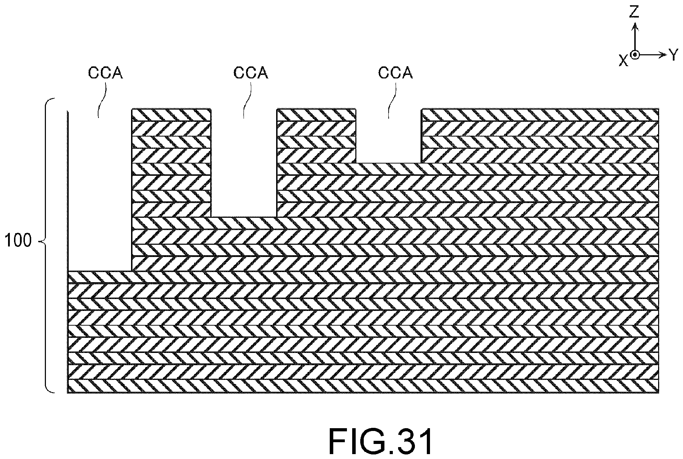

Subsequently, a plurality of concave portions CCA are formed in the stacked film 100 by lithography and RIE (FIGS. 30 and 31). As a result, the upper face of any one insulator 101 in the stacked film 100 is exposed in each concave portion CCA.

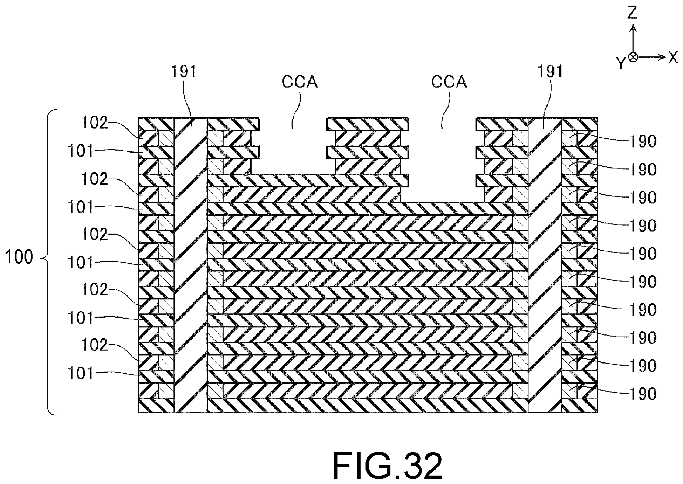

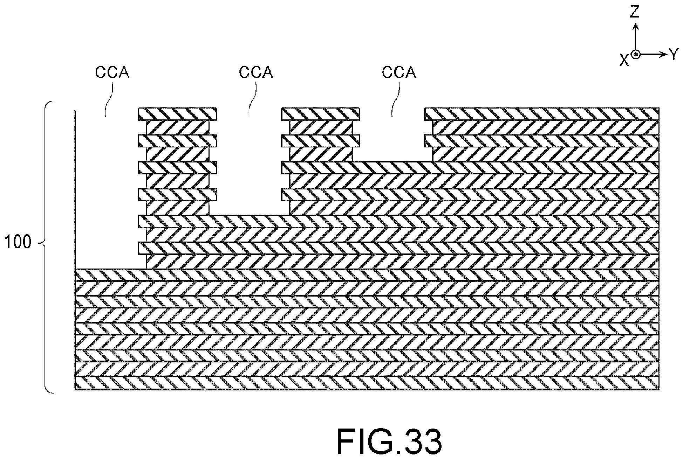

Subsequently, portions of the plurality of insulators 102 exposed on side faces of the respective concave portions CCA are removed by wet etching (FIGS. 32 and 33).

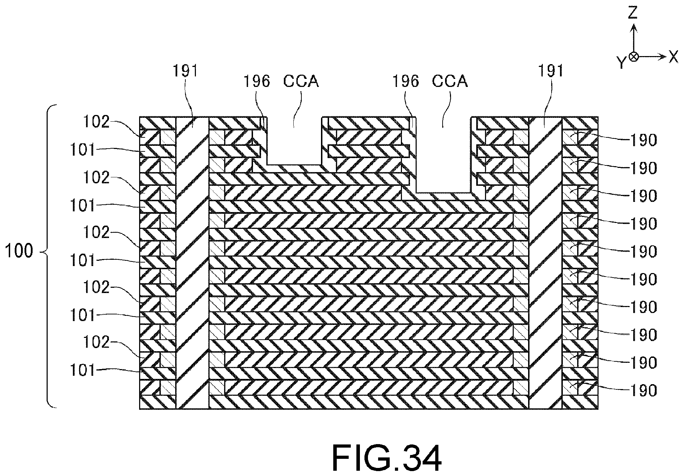

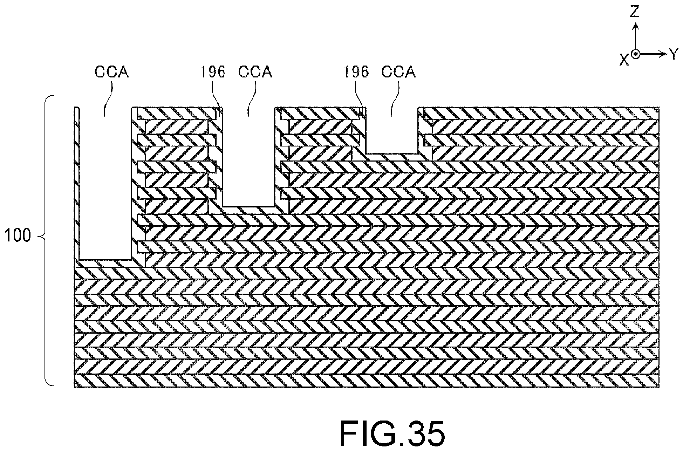

Subsequently, the insulators 196 are formed on the bottom faces and the side faces of the respective concave portions CCA by CVD (FIGS. 34 and 35).

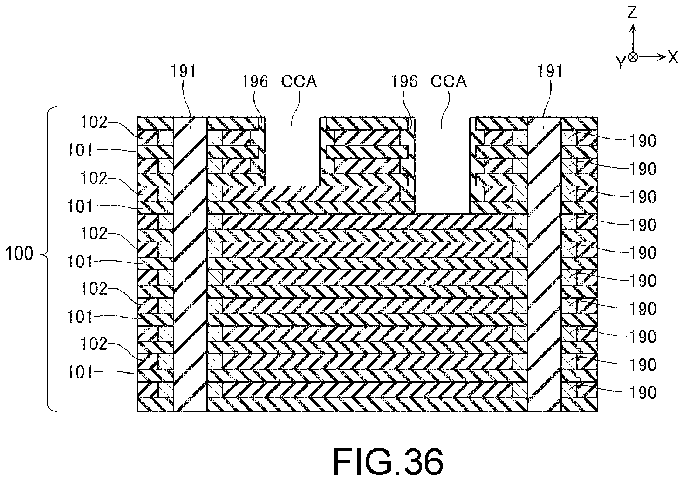

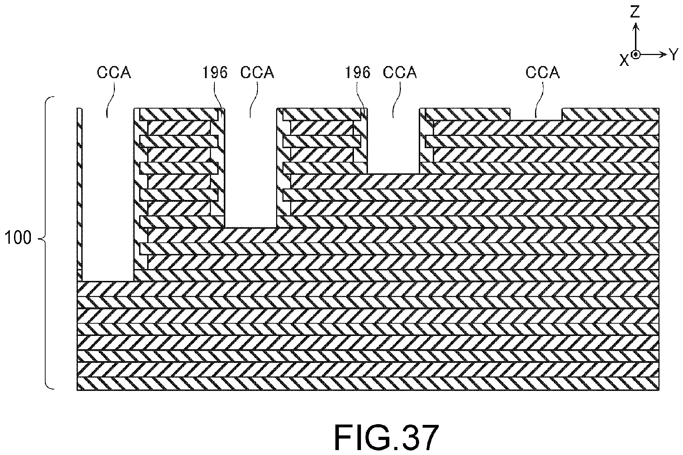

Subsequently, the insulators 196 and the insulators 101 are removed from the bottom faces of the respective concave portions CCA by RIE (FIGS. 36 and 37). As a result, the upper face of any one insulator 102 in the stacked film 100 is exposed in each concave portion CCA.

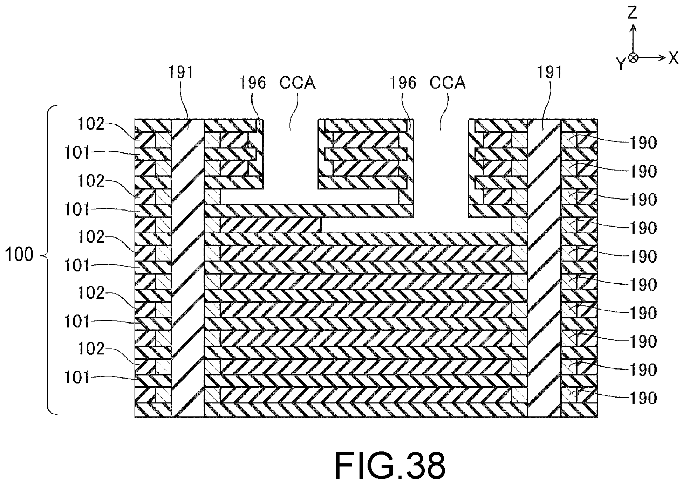

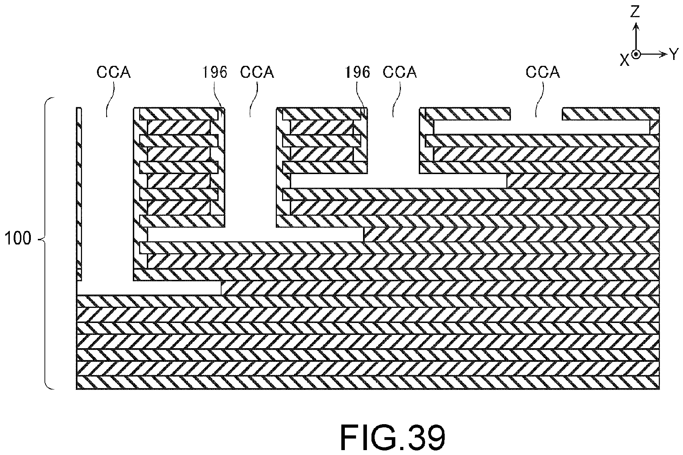

Subsequently, portions of the insulators 102 exposed on the bottom faces of the respective concave portions CCA are removed by wet etching (FIGS. 38 and 39). As a result, in each concave portion CCA, a side face of the corresponding interconnect layer 190 is exposed. Thereafter, the contact electrodes CC are formed in the respective concave portions CCA.

In this manner, the semiconductor device of the present embodiment is manufactured.

3) Details of semiconductor device of first embodiment

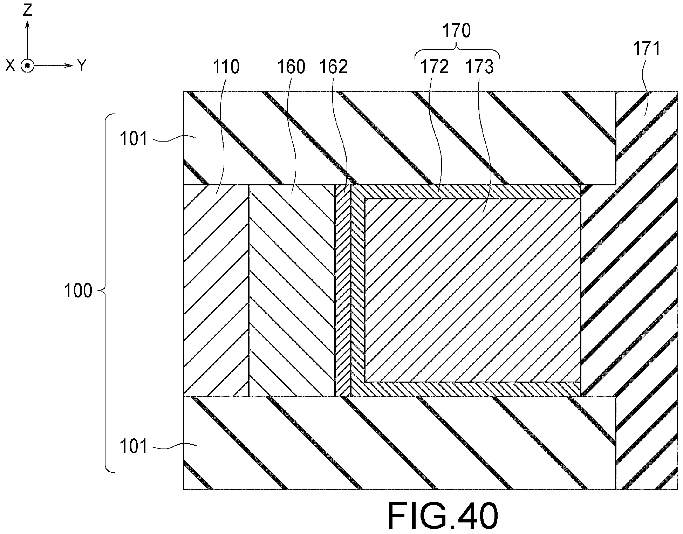

FIG. 40 is a cross-sectional view illustrating the structure of the semiconductor device of the first embodiment. FIG. 40 illustrates a YZ section along straight line L illustrated in FIGS. 3 and 4.

FIG. 40 illustrates the stacked film 100 including the plurality of insulators 101 separated from each other in the Z direction. FIG. 40 exemplarily illustrates two insulators 101 in the stacked film 100. Hereinafter, the upper insulator 101 among the two insulators 101 is referred to as an "upper insulator 101", the lower insulator 101 among the two insulators 101 is referred to as a "lower insulator 101", and the two insulators 101 are referred to as "upper and lower insulators 101". The lower insulator 101 is an example of the first insulator, and the upper insulator 101 is an example of the second insulator.

FIG. 40 further illustrates a semiconductor layer 110, a semiconductor layer 160, a metal layer 162, and an interconnect layer 170 provided between the upper and lower insulators 101. The semiconductor layer 110, the semiconductor layer 160, the metal layer 162, and the interconnect layer 170 illustrated in FIG. 40 are included in one memory layer ML (FIG. 4) in the stacked film 100. The semiconductor layer 110 is an example of the first semiconductor layer. The semiconductor layer 160 is an example of the second semiconductor layer. The metal layer 162 is an example of the first metal layer. The interconnect layer 170 is an example of the first interconnect.

The semiconductor layer 110 extends in the Y direction between the upper and lower insulators 101. The semiconductor layer 110 is, for example, a polysilicon layer. The semiconductor layer 110 of the present embodiment is an undoped polysilicon layer. The semiconductor layer 110 of the present embodiment is a channel semiconductor layer and functions as a channel region of a plurality of memory cells.

The semiconductor layer 160 is formed on a side face of the semiconductor layer 110. The semiconductor layer 110 is, for example, a polysilicon layer. The semiconductor layer 160 of the present embodiment is an impurity semiconductor layer and is, for example, an N-type polysilicon layer. The N-type impurity in the semiconductor layer 160 is, for example, phosphorus (P). The N-type impurity in the semiconductor layer 160 may be arsenic (As). In the present embodiment, since each semiconductor layer 110 is an undoped polysilicon layer and each semiconductor layer 160 is an impurity semiconductor layer, the semiconductor layer 160 has a composition different from the composition of the semiconductor layer 110.

The metal layer 162 is formed on a side face of the semiconductor layer 160. The metal layer 162 of the present embodiment has a plate-like shape two-dimensionally extending in a planar or curved manner (refer to FIG. 26, for example). Specifically, the metal layer 162 of the present embodiment extends in the Z direction and extends approximately in the X direction (or in a direction tilted with respect to the X direction). The metal layer 162 is, for example, a tungsten (W) layer. The metal layer 162 may be formed of a metal element other than tungsten. In this case, the metal layer 162 may be, for example, a molybdenum (Mo) layer, a technetium (Tc) layer, a ruthenium (Ru) layer, a rhodium (Rh) layer, a rhenium (Re) layer, an osmium (Os) layer, an iridium (Ir) layer, or a platinum (Pt) layer. By forming the metal layer 162 on the side face of the N-type semiconductor layer 160, the present embodiment makes it possible to lower the contact resistance between the semiconductor and the metal.

The interconnect layer 170 is formed on the side face of the metal layer 162 and extends in the X direction between the upper and lower insulators 101. Similarly to the semiconductor layer 110, the semiconductor layer 160, and the metal layer 162, the interconnect layer 170 contacts the lower face of the upper insulator 101 and the upper face of the lower insulator 101. The interconnect layer 170 further contacts a side face of the metal layer 162. The interconnect layer 170 functions as a local block interconnect LBI electrically connecting the semiconductor layer 110 (channel region) and an above-described interconnect layer 180 (bit line BL). The interconnect layer 180 is provided between the upper and lower insulators 101 and extends in the Y direction. The interconnect layer 180 is an example of the second interconnect. The interconnect layer 170 (local block interconnects LBI) illustrated in FIG. 40 is electrically connected to the interconnect layer 180 (bit line) provided between the upper and lower insulators 101 but may be electrically connected to an interconnect layer 180 (bit line) provided between other insulators 101.

The interconnect layer 170 includes a barrier metal layer 172 and an interconnect material layer 173. The barrier metal layer 172 is an example of a first layer. The interconnect material layer 173 is an example of a second layer.

The barrier metal layer 172 is formed on the side face of the metal layer 162, the lower face of the upper insulator 101, and the upper face of the lower insulator 101, and includes a side portion contacting the side face of the metal layer 162, an upper portion contacting the lower face of the upper insulator 101, and a lower portion contacting the upper face of the lower insulator 101. The side portion is an example of a second portion, the upper portion is an example of a third portion, and the lower portion is an example of a first portion. The barrier metal layer 172 is, for example, a titanium nitride film (TiN film). The interconnect material layer 173 is formed on a side face, the upper face, and the lower face of the barrier metal layer 172, and has a side face contacting the side face of the side portion, an upper face contacting the lower face of the upper portion, and a lower face contacting the upper face of the lower portion. In the present embodiment, the side face of the metal layer 162, the lower face of the upper insulator 101, and the upper face of the lower insulator 101 contact the barrier metal layer 172 but do not contact the interconnect material layer 173.

FIG. 40 further illustrates an insulator 171 provided on a side face of the stacked film 100. In FIG. 40, a portion of the insulator 171 is formed between the upper and lower insulators 101. As a result, the insulator 171 is formed on a side face of the interconnect layer 170, a side face and the lower face of the upper insulator 101, and a side face and the upper face of the lower insulator 101.

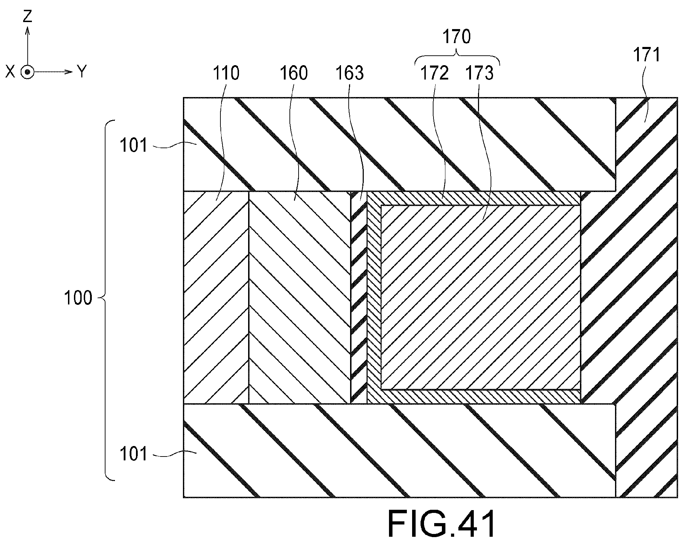

FIG. 41 is a cross-sectional view illustrating the structure of a semiconductor device of a comparative example of the first embodiment.

The semiconductor device of the present comparative example (FIG. 41) has the same structure as the semiconductor device of the first embodiment (FIG. 40). However, the semiconductor device of the present comparative example includes a native oxide film 163 in place of the metal layer 162.

The native oxide film 163 is an oxide film formed through oxidation of a portion of the semiconductor layer 160 due to natural oxidation from the side face of the semiconductor layer 160. The native oxide film 163 is, for example, a $SiO_2$ film. Similarly to the metal layer 162 of the first embodiment, the native oxide film 163 of the present comparative example has a plate-like shape two-dimensionally extending in a planar or curved manner.

The semiconductor layer 160 of the present comparative example is formed as follows. First, the semiconductor layer 160 is formed on the side face of the semiconductor layer 110 by CVD in a chamber of a CVD apparatus. In this case, the semiconductor layer 160 is formed not only between the upper and lower insulators 101 but also on the side face of the stacked film 100. Subsequently, the semiconductor layer 160 is removed from the side face of the stacked film 100 and the like by wet etching outside the chamber of the CVD apparatus. As a result, the semiconductor layer 160 is processed into a shape illustrated in FIG. 41. The wet etching is performed in an etching apparatus that is provided outside the chamber of the CVD apparatus.

In the present comparative example, the substrate Sub (FIG. 4) is taken out of the chamber of the CVD apparatus in the process of forming the semiconductor layer 160. That is, the substrate Sub is sent from the chamber of the CVD apparatus to the etching apparatus. To form the interconnect layer 170, the substrate Sub is then taken out of the etching apparatus. That is, the substrate Sub is sent from the etching apparatus to the chamber of the CVD apparatus. As a result, after the wet etching, the native oxide film 163 is formed on the side face of the semiconductor layer 160 as illustrated in FIG. 41. Thus, the resistance between the semiconductor layer 160 and the interconnect layer 170 becomes high due to the native oxide film 163.

However, in the present embodiment, in place of the native oxide film 163, the metal layer 162 is formed between the semiconductor layer 160 and the interconnect layer 170. This makes it possible to lower the resistance between the semiconductor layer 160 and the interconnect layer 170. A method of achieving such a structure will be described later.

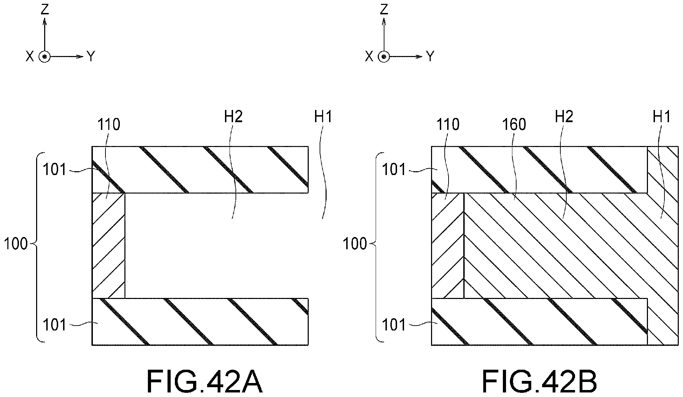

FIGS. 42A to 45B are cross-sectional views illustrating the method of manufacturing the semiconductor device of the first embodiment.

FIG. 42A illustrates the semiconductor layer 110 formed between the upper and lower insulators 101, a concave portion H2 provided between the upper and lower insulators 101, and a concave portion H1 provided at the side face of the stacked film 100. The state illustrated in FIG. 42A corresponds to the state illustrated in FIG. 25.

More specifically, the concave portions H1 and H2 are filled with an insulator 102 and the like. However, in FIG. 42A and other diagrams, illustration of the insulator 102 and the like is omitted to facilitate understanding of description. As described later, the insulator 102 and the like are removed from the concave portions H1 and H2 before the semiconductor layer 160, the metal layer 162, the interconnect layer 170, the insulator 171, and the like are formed in the concave portions H1 and H2 (refer to FIGS. 26 to 29).

Subsequently, the semiconductor layer 160 is formed on the side face of the semiconductor layer 110 (FIG. 42B). As a result, the semiconductor layer 160 is formed not only between the upper and lower insulators 101 but also on the side face of the stacked film 100. In other words, the semiconductor layer 160 is formed not only in the concave portion H2 but also in the concave portion H1. The semiconductor layer 160 of the present embodiment is formed of by CVD in a chamber of a CVD apparatus.

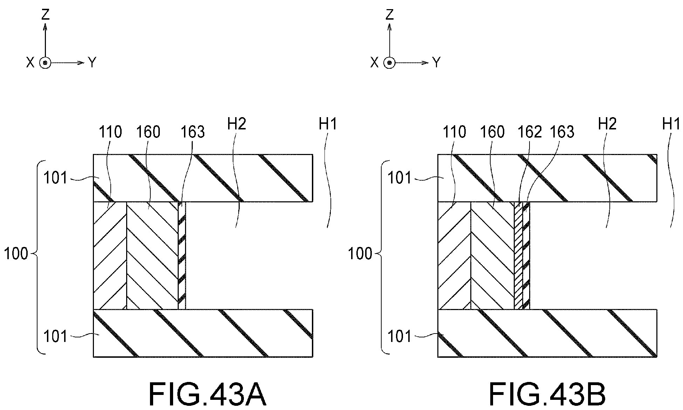

Subsequently, the semiconductor layer 160 is removed from the side face of the stacked film 100 and the like (FIG. 43A). As a result, the semiconductor layer 160 in the concave portion H1 is removed, and in addition, a portion of the semiconductor layer 160 in the concave portion H2 is removed. The removal of the semiconductor layer 160 of the present embodiment is performed by wet etching outside the chamber of the CVD apparatus. The wet etching is performed in an etching apparatus that is provided outside the chamber of the CVD apparatus. To form the interconnect layer 170 including the barrier metal layer 172 and the interconnect material layer 173 to be described later, the substrate Sub (FIG. 4) is then taken out of the etching apparatus. That is, the substrate Sub is sent from the etching apparatus to the chamber of the CVD apparatus.

Thus, after the wet etching, the native oxide film 163 is formed on the side face of the semiconductor layer 160 (FIG. 43A). As in the above-described comparative example, the native oxide film 163 of the present embodiment is an oxide film formed through oxidation of a portion of the semiconductor layer 160 due to natural oxidation from the side face of the semiconductor layer 160. The native oxide film 163 is, for example, a $SiO_2$ film. The native oxide film 163 has a plate-like shape two-dimensionally extending in a planar or curved manner.

Subsequently, conversion processing is performed to convert a portion of the semiconductor layer 160 into the metal layer 162 from the side face of the semiconductor layer 160 (FIG. 43B). As a result, the metal layer 162 is formed on the side face of the semiconductor layer 160 between the semiconductor layer 160 and the native oxide film 163 in the concave portion H2.

In the conversion processing, the reaction represented by Chemical Formula (1) below occurs.

$$2WF_6 + 3Si \rightarrow 2W + 3SiF_4 \ldots (1)$$

In the formula, "W", "F", and "Si" represent tungsten, fluorine, and silicon, respectively. The left-hand side of Chemical Formula (1) indicates that gas $WF_6$ for the conversion processing reacts with Si atoms in the semiconductor layer 160. The right-hand side of Chemical Formula (1) indicates that a portion of the semiconductor layer 160 (Si layer) is converted into the metal layer 162 (W layer) and $SiF_4$ gas is generated.

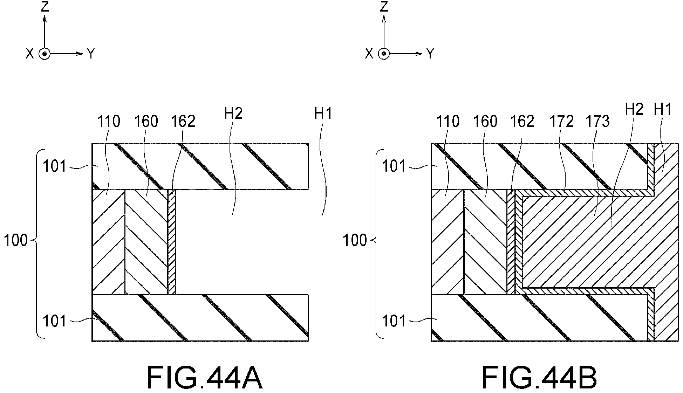

Subsequently, the native oxide film 163 is removed by wet etching (FIG. 44A). As a result, the native oxide film 163 is removed from the side face of the metal layer 162. Natural oxidation of the semiconductor layer 160 after the wet etching is suppressed since the side face of the semiconductor layer 160 is covered with the metal layer 162. The wet etching may be omitted so that the native oxide film 163 remains on the side face of the metal layer 162. This is because the native oxide film 163 remains between a metal (metal layer 162) and a metal (interconnect layer 170), not between a semiconductor and a metal.

Subsequently, the barrier metal layer 172 and the interconnect material layer 173 are sequentially formed in the concave portions H1 and H2 (FIG. 44B). As a result, the barrier metal layer 172 is formed on the side face of the metal layer 162, the lower face and the side face of the upper insulator 101, and the upper face and the side face of the lower insulator 101, and the interconnect material layer 173 is formed on the side face, the upper face, and the lower face of the barrier metal layer 172.

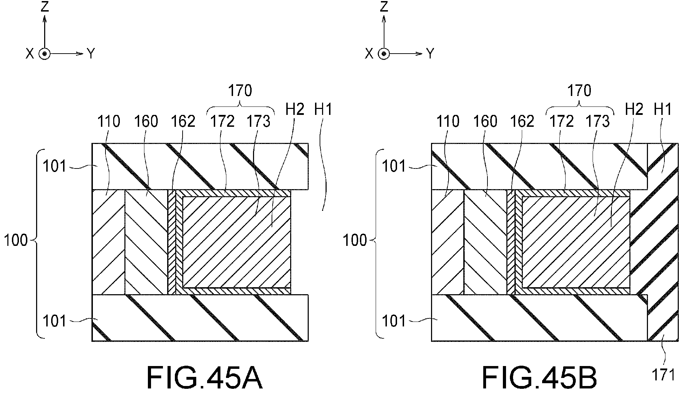

Subsequently, the barrier metal layer 172 and the interconnect material layer 173 are removed from the side face of the stacked film 100 and the like (FIG. 45A). As a result, the barrier metal layer 172 and the interconnect material layer 173 in the concave portion H1 are removed, and in addition, portions of the barrier metal layer 172 and the interconnect material layer 173 in the concave portion H2 are removed. In this manner, the interconnect layer 170 illustrated in FIG. 40 is formed. In FIG. 40, the interconnect layer 170 contacts the side face of the metal layer 162, the lower face of the upper insulator 101, and the upper face of the lower insulator 101. The above-described interconnect layer 180 may be simultaneously formed with the interconnect layer 170 or may be sequentially formed with the interconnect layer 170.

Subsequently, the insulator 171 is formed in the concave portions H1 and H2 (FIG. 45B). In this manner, the semiconductor device of the present embodiment is manufactured.

As indicated by Chemical Formula (1), the metal layer 162 of the present embodiment is formed by converting a portion of the semiconductor layer 160 into the metal layer 162 by using $WF_6$ gas. Thus, the metal layer 162 may include W atoms and F atoms. For example, the metal layer 162 may be a W layer including F atoms as impurity atoms.

As described above, the semiconductor device of the present embodiment includes the metal layer 162 between the semiconductor layer 160 and the interconnect layer 170 (FIG. 40). Accordingly, the present embodiment makes it possible to lower the resistance between the semiconductor layer 160 and the interconnect layer 170.

(Second embodiment)

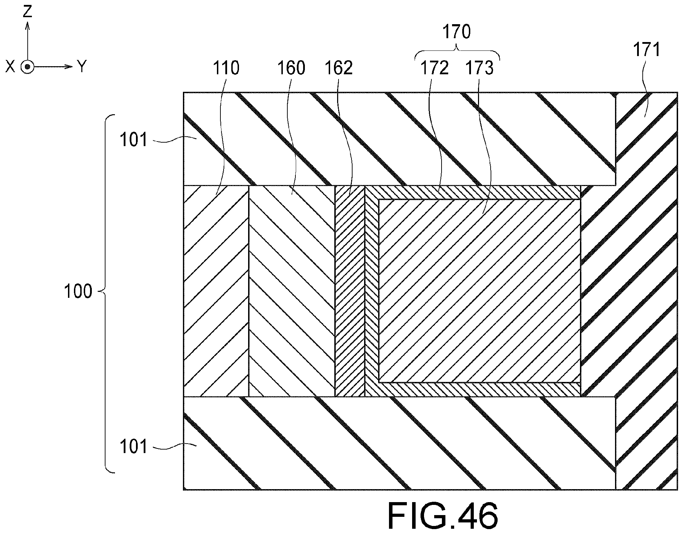

FIG. 46 is a cross-sectional view illustrating the structure of a semiconductor device of a second embodiment.

The semiconductor device of the present embodiment (FIG. 46) has the same structure as the semiconductor device of the first embodiment (FIG. 40). However, the metal layer 162 of the present embodiment is formed by a method different from that for the metal layer 162 of the first embodiment. As a result, the thickness of the metal layer 162 of the present embodiment is different from the thickness of the metal layer 162 of the first embodiment, and for example, the thickness of a metal layer 162 illustrated in FIG. 46 in the Y direction is larger than the thickness of the metal layer 162 illustrated in FIG. 40 in the Y direction. However, the thickness of the metal layer 162 of the present embodiment may be the same as or smaller than the thickness of the metal layer 162 of the first embodiment.

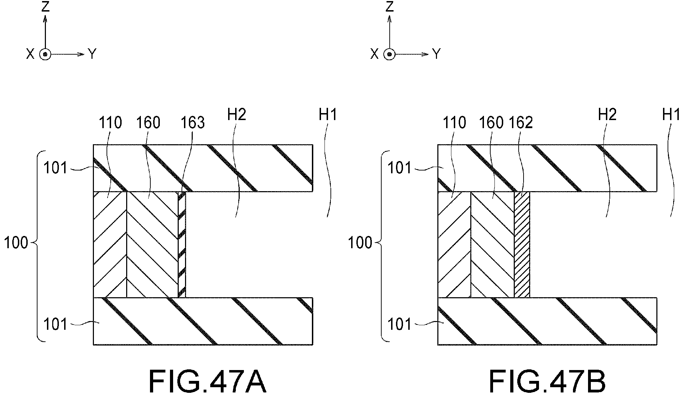

FIGS. 47A and 47B are cross-sectional views illustrating a method of manufacturing the semiconductor device of the second embodiment.

First, the processes in FIGS. 42A to 43A are performed. As a result, a structure illustrated in FIG. 47A is formed. The state illustrated in FIG. 47A corresponds to the state illustrated in FIG. 43A.

Subsequently, conversion processing is performed to convert all of the native oxide film 163 and a portion of the semiconductor layer 160 into the metal layer 162 from a side face of the native oxide film 163 (FIG. 47B). As a result, the metal layer 162 is formed on the side face of the semiconductor layer 160 in the concave portion H2.

In the conversion processing of the present embodiment, not only the reaction represented by Chemical Formula (1) above but also the reaction represented by Chemical Formulae (2) and (3) below occur.

$$WF_6 + 3H_2 \rightarrow W + 6HF \ \dots \ (2)$$

$$SiO_2 + 4HF \rightarrow SiF_4 + 2H_2O \ \dots \ (3)$$

In the formulae, "W", "F", "H", and "Si" represent tungsten, fluorine, hydrogen, and silicon, respectively. Chemical Formula (2) indicates that gas $WF_6$ and $H_2$ for the conversion processing react to generate W and HF. Chemical Formula (3) indicates that the above-described HF reacts with $SiO_2$ in the native oxide film 163 to generate $SiF_4$ and $H_2O$. Through the reaction represented by Chemical Formulae (2) and (3), the native oxide film 163 ($SiO_2$ film) is converted into the metal layer 162 (W layer). In addition, through the reaction represented by Chemical Formula (1) above, the semiconductor layer 160 (Si layer) is converted into the metal layer 162 (W layer).

In the present embodiment, the reaction represented by Chemical Formulae (2) and (3) proceeds until the native oxide film 163 disappears, and the reaction represented by Chemical Formula (1) ends before the semiconductor layer 160 disappears. As a result, all of the native oxide film 163 and a portion of the semiconductor layer 160 are converted into the metal layer 162. The present embodiment makes it possible to form the metal layer 162 by the conversion processing even if the thickness of the native oxide film 163 is large.

Subsequently, the processes in FIGS. 44B to 45B are performed. In this manner, the semiconductor device of the present embodiment is manufactured.

The metal layer 162 of the present embodiment is formed by converting all of the native oxide film 163 and a portion of the semiconductor layer 160 into the metal layer 162 by using $WF_6$ gas and $H_2$ as indicated by

Chemical Formulae (1) to (3). Thus, the metal layer 162 (or interface between the metal layer 162 and the interconnect layer 170) may include not only W atoms but also at least one of F atoms, H atoms, and O atoms. For example, the metal layer 162 may be a W layer including F atoms as impurity atoms, and the interface between the metal layer 162 and the interconnect layer 170 may include O atoms as impurity atoms.

As described above, the semiconductor device of the present embodiment includes the metal layer 162 between the semiconductor layer 160 and the interconnect layer 170 (FIG. 46). Thus, similarly to the first embodiment, the present embodiment makes it possible to lower the resistance between the semiconductor layer 160 and the interconnect layer 170.

(Third embodiment)

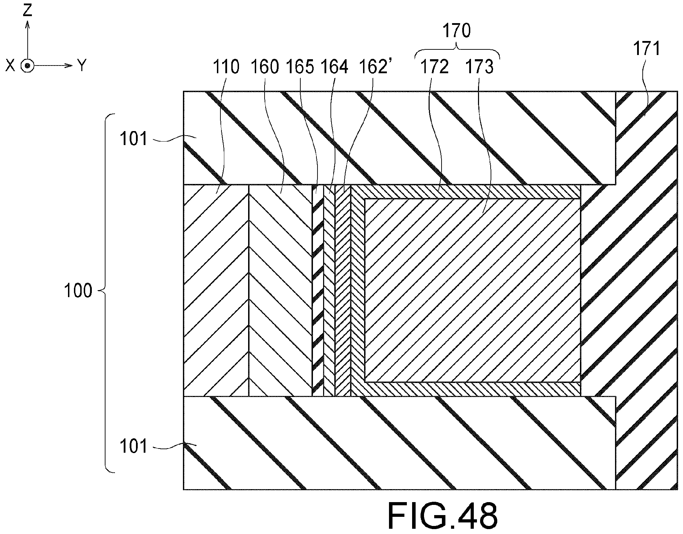

FIG. 48 is a cross-sectional view illustrating the structure of a semiconductor device of a third embodiment.

The semiconductor device of the present embodiment (FIG. 48) has the same structure as the semiconductor device of the first embodiment (FIG. 40). However, the semiconductor device of the present embodiment includes a nitride film 165, a metal silicon nitride film 164, and a metal layer 162' in place of the metal layer 162. The nitride film 165, the metal silicon nitride film 164, and the metal layer 162' are included in a memory layer ML (FIG. 4) provided between the upper and lower insulators 101. Similarly to the metal layer 162 of the first embodiment, the metal layer 162' is an example of the first metal layer. The metal layer 162' is also an example of a fifth metal layer. The metal silicon nitride film 164 is an example of a second metal layer. The nitride film 165 is an example of a first film.

The nitride film 165 is formed on the side face of the semiconductor layer 160 and sandwiched between the semiconductor layer 160 and the metal silicon nitride film 164. The metal silicon nitride film 164 is formed on a side face of the nitride film 165 and sandwiched between the nitride film 165 and the metal layer 162'. The metal layer 162' is formed on a side face of the metal silicon nitride film 164 and sandwiched between the metal silicon nitride film 164 and the interconnect layer 170. Similarly to the metal layer 162 of the first embodiment, each of the nitride film 165, the metal silicon nitride film 164, and the metal layer 162' of the present embodiment has a plate-like shape two-dimensionally extending in a planar or curved manner.

The nitride film 165, the metal silicon nitride film 164, and the metal layer 162' are, for example, a SiN film, a tungsten silicon nitride film (WSiN film), and a tungsten (W) layer, respectively. The metal silicon nitride film 164 and the metal layer 162' may be formed of a metal element other than tungsten. In this case, the metal silicon nitride film 164 and the metal layer 162' may be, for example, a molybdenum silicon nitride film (MoSiN film) and a molybdenum (Mo) layer, respectively. Examples of metal elements other than tungsten and molybdenum include technetium (Tc), ruthenium (Ru), rhodium (Rh), rhenium (Re), osmium (Os), iridium (Ir), and platinum (Pt).

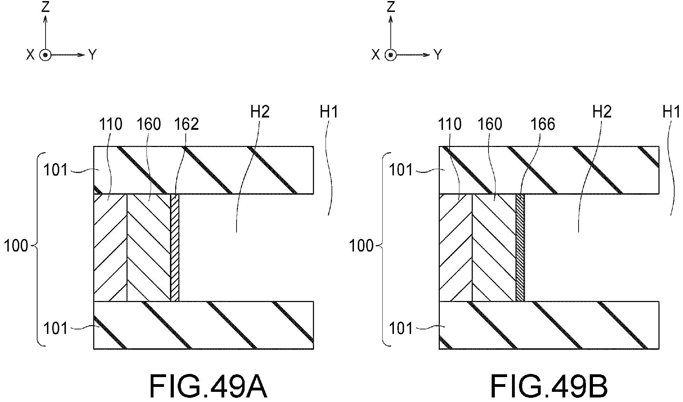

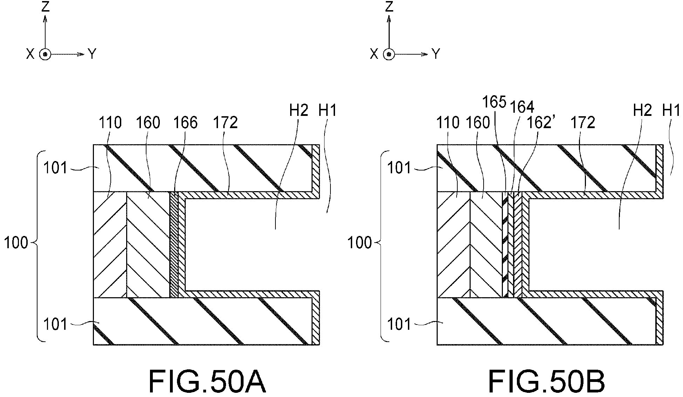

FIGS. 49A and 50B are cross-sectional views illustrating a method of manufacturing the semiconductor device of the third embodiment.

First, the processes in FIGS. 42A to 44A are performed. As a result, a structure illustrated in FIG. 49A is formed. The state illustrated in FIG. 49A corresponds to the state illustrated in FIG. 44A. As described above, a metal layer 162 illustrated in FIG. 49A is, for example, a tungsten (W) layer. The metal layer 162 illustrated in FIG. 49A is an example of a third metal layer.

Subsequently, the metal layer 162 is nitrided (FIG. 49B). As a result, the metal layer 162 changes to a metal nitride film 166. The metal nitride film 166 is, for example, a tungsten nitride film (WN film). The metal nitride film 166 is an example of a fourth metal layer.

Subsequently, the barrier metal layer 172 is formed in the concave portions H1 and H2 (FIG. 50A). As a result, the barrier metal layer 172 is formed on a side face of the metal nitride film 166, the lower face and the side face of the upper insulator 101, and the upper face and the side face of the lower insulator 101.

Subsequently, the metal nitride film 166 is heated (FIG. 50B). Accordingly, N atoms in the metal nitride film 166 diffuse toward the semiconductor layer 160. As a result, the metal nitride film 166 changes to the metal layer 162'. In addition, the metal silicon nitride film 164 is formed on a side face of the metal layer 162' between the metal layer 162' and the semiconductor layer 160. Furthermore, the nitride film 165 is formed on a side face of the metal silicon nitride film 164 between the metal layer 162' and the semiconductor layer 160. In FIG. 50B, the metal silicon nitride film 164 is formed on a side face of the metal layer 162' on the negative side in the Y direction, and the nitride film 165 is formed on a side face of the metal silicon nitride film 164 on the negative side in the Y direction. As described above, the metal layer 162', the metal silicon nitride film 164, and the nitride film 165 are, for example, a W layer, a WSiN film, and a SiN film, respectively. In the present embodiment, W atoms in the metal silicon nitride film 164 are derived from W atoms in the metal nitride film 166, N atoms in the metal silicon nitride film 164 and the nitride film 165 are derived from N atoms in the metal nitride film 166, and Si atoms in the metal silicon nitride film 164 and the nitride film 165 are derived from Si atoms in the semiconductor layer 160.

Subsequently, the processes in FIGS. 44B to 45B are performed (except for the process of forming the barrier metal layer 172). In this manner, the semiconductor device of the present embodiment is manufactured.

In the present embodiment, through the process in FIG. 50B, the nitride film 165 is formed between the semiconductor layer 160 and the interconnect layer 170.

The nitride film 165 increases the resistance between the semiconductor layer 160 and the interconnect layer 170. However, by forming the nitride film 165 between the semiconductor layer 160 and the interconnect layer 170, the present embodiment makes it possible to suppress a large number of Si atoms from diffusing from the semiconductor layer 160, and accordingly, suppress large-sized or a large number of voids from being generated in the semiconductor layer 160. The adverse effect of the voids on the resistance is greater than the adverse effect of the nitride film 165 on the resistance. By forming the nitride film 165 to suppress void generation, the present embodiment makes it possible to lower the resistance of the entire region including the semiconductor layer 160, the interconnect layer 170, and portions (165, 164, and 162') therebetween. By forming the nitride film 165 between the semiconductor layer 160 and the interconnect layer 170, the present embodiment makes it possible to suppress a large number of Si atoms from diffusing from the semiconductor layer 160 even if heat is applied to the semiconductor layer 160 after formation of the interconnect layer 170.

The metal layer 162' of the present embodiment is formed through nitridation of the metal layer 162 and N atom diffusion from the metal nitride film 166. Thus, the metal layer 162' (or interface between the metal layer 162' and the interconnect layer 170) may include W atoms and N atoms. For example, the metal layer 162' may be a W layer including N atoms as impurity atoms, and the interface between the metal layer 162' and the interconnect layer 170 may include N atoms as impurity atoms.

As described above, the semiconductor device of the present embodiment includes the metal layer 162' and the like between the semiconductor layer 160 and the interconnect layer 170 (FIG. 48). Thus, similarly to the first and second embodiments, the present embodiment makes it possible to lower the resistance between the semiconductor layer 160 and the interconnect layer 170.

In the first to third embodiments, it is possible to investigate whether the semiconductor devices of the respective embodiments have the structures illustrated in FIGS. 40, 46, 48, and other diagrams, by analysis such as energy dispersive x-ray spectroscopy (EDS). EDS is also referred to as EDX. The boundaries between layers of each embodiment may be formed in a state in which it is difficult to distinguish the boundaries. For example, the boundaries between the semiconductor layer 110, the semiconductor layer 160, the metal layer 162, the barrier metal layer 172, and the interconnect material layer 173 of the first or second embodiment and the boundaries between the semiconductor layer 110, the semiconductor layer 160, the nitride film 165, the metal silicon nitride film 164, the metal layer 162', the barrier metal layer 172, and the interconnect material layer 173 of the third embodiment may be formed in a state in which it is difficult to distinguish the boundaries. In this case, these layers may be referred to as "semiconductor region 110", "semiconductor region 160", "metal region 162", and the like.

While certain embodiments have been described, these embodiments have been presented by way of example only, and are not intended to limit the scope of the inventions. Indeed, the novel devices and methods described herein may be embodied in a variety of other forms; furthermore, various omissions, substitutions and changes in the form of the devices and methods described herein may be made without departing from the spirit of the inventions. The accompanying claims and their equivalents are intended to cover such forms or modifications as would fall within the scope and spirit of the inventions.

## Claims

1. A semiconductor device comprising:

    a substrate;
    a stacked film provided on the substrate, and including a plurality of insulators separated from each other in a first direction orthogonal to a surface of the substrate;
    a first semiconductor layer provided between first and second insulators included in the plurality of insulators, and extending in a second direction orthogonal to the first direction, the first semiconductor layer being a channel semiconductor layer;
    a second semiconductor layer provided on a side face of the first semiconductor layer between the first and second insulators, and having a composition different from a composition of the first semiconductor layer;
    a first metal layer provided on a side face of the second semiconductor layer between the first and second insulators;
    a first interconnect provided on a side face of the first metal layer between the first and second insulators; and
    a second interconnect extending in the second direction, and electrically connected to the first interconnect, the second interconnect being a bit line.

2. The device of Claim 1, wherein the first interconnect extends in a third direction orthogonal to the first direction and the second direction.

3. The device of Claim 1, wherein the second semiconductor layer is an impurity semiconductor layer.

4. The device of Claim 1, wherein the first metal layer includes tungsten (W), molybdenum (Mo), technetium (Tc), ruthenium (Ru), rhodium (Rh), rhenium (Re), osmium (Os), iridium (Ir) or platinum (Pt).

5. The device of Claim 1, wherein the first metal layer includes fluorine (F).

6. The device of Claim 1, wherein the first metal layer includes nitrogen (N).

7. The device of Claim 1, wherein an interface between the first metal layer and the first interconnect includes oxygen (O).

8. The device of Claim 1, wherein an interface between the first metal layer and the first interconnect includes nitrogen (N).

9. The device of Claim 1, wherein the first interconnect includes:

   a first layer including a first portion contacting an upper face of the first insulator, a second portion contacting the side face of the first metal layer, and a third portion contacting a lower face of the second insulator, and
   a second layer having a lower face contacting the first portion, a side face contacting the second portion, and an upper face contacting the third portion.

10. The device of Claim 1, further comprising a second metal layer provided between the second semiconductor layer and the first metal layer, wherein

    the first metal layer includes a metal element, and
    the second metal layer includes the metal element, silicon (Si) and nitrogen (N).

11. The device of Claim 10, wherein the metal element is tungsten (W), molybdenum (Mo), technetium (Tc), ruthenium (Ru), rhodium (Rh), rhenium (Re), osmium (Os), iridium (Ir) or platinum (Pt).

12. The device of Claim 10, further comprising a first film provided between the second semiconductor layer and the second metal layer, wherein the first film includes silicon (Si) and nitrogen (N).

13. A semiconductor device comprising:

    a stacked film including a plurality of insulators separated from each other in a first direction;
    a first semiconductor layer provided between first and second insulators included in the plurality of insulators;
    a second semiconductor layer provided on a side face of the first semiconductor layer between the first and second insulators;
    a first metal layer provided on a side face of the second semiconductor layer between the first and second insulators, and including tungsten (W), molybdenum (Mo), technetium (Tc), ruthenium (Ru), rhodium (Rh), rhenium (Re), osmium (Os), iridium (Ir) or platinum (Pt); and
    a first interconnect provided on a side face of the first metal layer between the first and second insulators.

14. The device of Claim 13, wherein the first interconnect contacts an upper face of the first insulator and a lower face of the second insulator.

15. The device of Claim 13, further comprising a second interconnect electrically connected to the first interconnect.

16. The device of Claim 15, wherein the second interconnect is a bit line.

17. A method of manufacturing a semiconductor device, comprising:

    forming a stacked film including a plurality of insulators separated from each other in a first direction;
    forming a first semiconductor layer between first and second insulators included in the plurality of insulators;
    forming a second semiconductor layer on a side face of the first semiconductor layer between the first and second insulators;
    forming a first metal layer on a side face of the second semiconductor layer between the first and second insulators;
    forming, on a side face of the first metal layer between the first and second insulators, a first interconnect contacting an upper face of the first insulator and a lower face of the second insulator; and
    forming a second interconnect electrically connected to the first interconnect.

18. The method of Claim 17, wherein the first metal layer is formed by converting a portion of the second semiconductor layer into the first metal layer.

19. The method of Claim 17, wherein the first metal layer is formed by a first step of converting a native oxide film formed on the side face of the second semiconductor layer into a third metal layer, a second step of changing the third metal layer to a fourth metal layer through nitridation, and a third step of changing the fourth metal layer to a fifth metal layer.

20. The method of Claim 19, wherein at least a portion of the first interconnect is formed after the second step and before the third step.

FIG. 1

FIG. 2

**FIG. 3**

FIG. 4

FIG. 5

FIG. 6

FIG. 7

FIG. 8

FIG. 9

FIG.10

FIG.11

FIG.12

FIG.13

FIG.14

Y
Z ⊙ → X

171A    171A    171A    171A    102

$R_{LBI}$

181A

182

181A

182

181A

182

181A

161B

$R_{SGD}$

150A

140B

$R_{MC}$

120B

120B

123

$R_{BL}$          $R_{BLK}$

# FIG.15

FIG.16

FIG.17

Y
Z⊙→X

171B 171B 171B 171B 102

$R_{LBI}$

181B

182

161B

$R_{SGD}$

181B

150B

182

181B

140B

$R_{MC}$

182

120A

181B

120A

123

$R_{BL}$ $R_{BLK}$

# FIG.18

FIG.19

FIG.20

FIG.21

FIG.22

FIG.23

FIG.24

FIG.25

FIG.26

FIG.27

FIG.28

FIG.29

FIG.30

FIG.31

FIG.32

FIG.33

FIG.34

FIG.35

FIG.36

FIG.37

FIG.38

CCA     196   CCA     196   CCA         CCA

Z

X → Y

100

## FIG.39

FIG.40

FIG.41

FIG.42A

FIG.42B

FIG.43A

FIG.43B

FIG.44A

FIG.44B

FIG.45A

FIG.45B

FIG.46

FIG.47A

FIG.47B

FIG.48

FIG.49A

FIG.49B

FIG.50A

FIG.50B

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/302016 A1 (MATSUO KOUJI [JP] ET AL) 22 September 2022 (2022-09-22) | 1-4, 13-17 | INV.<br>H10B43/10 |
| Y | * the whole document * | 5-9,18 | H10B43/20 |
| A | | 10-12, 19,20 | H10B43/50 |
| | ----- | | |
| Y | US 2022/359398 A1 (KONG LINGYU [SG] ET AL) 10 November 2022 (2022-11-10) | 6,8,9 | |
| A | * paragraphs [0050], [0091] - [0093]; figures 1N, and relative passages in the description * | 1,13,17 | |
| | ----- | | |
| A | US 2016/225785 A1 (KIM CHAEHO [KR] ET AL) 4 August 2016 (2016-08-04)<br>* figures 4, and relative passages in the description * | 1,13,17 | |
| | ----- | | |
| Y | US 5 071 788 A (JOSHI RAJIV V [US]) 10 December 1991 (1991-12-10)<br>* the whole document * | 5,7,18 | |
| | ----- | | **TECHNICAL FIELDS SEARCHED (IPC)**<br><br>H10B |

The present search report has been drawn up for all claims

| Place of search | Date of completion of the search | Examiner |
|---|---|---|
| Munich | 5 December 2025 | Alessio Verni, G |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

................................................................
& : member of the same patent family, corresponding
document

EPO FORM 1503 03.82 (P04C01)

**EP 4 757 522 A1**

## ANNEX TO THE EUROPEAN SEARCH REPORT
## ON EUROPEAN PATENT APPLICATION NO.

EP 25 19 2062

This annex lists the patent family members relating to the patent documents cited in the above-mentioned European search report.
The members are as contained in the European Patent Office EDP file on
The European Patent Office is in no way liable for these particulars which are merely given for the purpose of information.

05-12-2025

| Patent document cited in search report | | Publication date | Patent family member(s) | | Publication date |
|---|---|---|---|---|---|
| US 2022302016 | A1 | 22-09-2022 | CN | 115116519 A | 27-09-2022 |
| | | | JP | 2022146819 A | 05-10-2022 |
| | | | TW | 202238940 A | 01-10-2022 |
| | | | US | 2022302016 A1 | 22-09-2022 |
| | | | US | 2025201708 A1 | 19-06-2025 |
| US 2022359398 | A1 | 10-11-2022 | CN | 115312524 A | 08-11-2022 |
| | | | US | 2022359398 A1 | 10-11-2022 |
| | | | US | 2024347464 A1 | 17-10-2024 |
| US 2016225785 | A1 | 04-08-2016 | CN | 105845687 A | 10-08-2016 |
| | | | US | 2016225785 A1 | 04-08-2016 |
| | | | US | 2016365357 A1 | 15-12-2016 |
| US 5071788 | A | 10-12-1991 | NONE | | |

EPO FORM P0459

For more details about this annex : see Official Journal of the European Patent Office, No. 12/82